# EUROPEAN PATENT APPLICATION

(11) **EP 4 780 193 A1**
(43) Date of publication of application: **22.07.2026**
(21) Application number: 25198065.2
(22) Date of filing: 26.08.2025
(51) Int. Cl.: H10W 20/43

(54) **SEMICONDUCTOR DEVICE**

(30) Priority: 15.01.2025 KR 20250006357
(71) Applicant: Samsung Electronics Co., Ltd., Suwon-si, Gyeonggi-do 16677 (KR)
(72) Inventor: NA, Sangcheol, Suwon-si, Gyeonggi-do 16677 (KR); HWANG, InKyoung, Suwon-si, Gyeonggi-do 16677 (KR); GWAK, Minchan, Suwon-si, Gyeonggi-do 16677 (KR); LEE, Kyoungwoo, Suwon-si, Gyeonggi-do 16677 (KR); HA, Seungseok, Suwon-si, Gyeonggi-do 16677 (KR)
(74) Representative: Kuhnen & Wacker Patent- und Rechtsanwaltsbüro PartG mbB

(57) **Abstract**

A semiconductor device includes a base insulating layer (200) comprising an upper surface and a lower surface opposing one another, a channel structure (CH) on the upper surface of the base insulating layer (200), a gate structure (GS) surrounding the channel structure (CH), source/drain patterns (150) on the upper surface of the base insulating layer (200) and connected to the channel structure (CH), power rails (220) on the lower surface of the base insulating layer (200), and one or more lower contact electrodes (181) connecting one or more of the power rails (220) to one or more of the source/drain patterns (150), wherein a lower surface of a first lower contact electrode of the one or more lower contact electrodes (181) is positioned at a level higher than the lower surface of the base insulating layer (200).

## Description

### BACKGROUND

Semiconductor devices are used in various electronic devices, such as storage devices that store data and processors that perform computational processing of data. With the development of the electronics industry, various methods are being studied to improve the various characteristics of semiconductor devices, such as integration, reliability, speed, and function. For example, semiconductor devices with three-dimensional structures are being proposed to overcome limitations due to the reduction in the size of semiconductor devices.

Recently, research is being conducted to improve routing congestion and scale the size of semiconductor devices by placing the power delivery network (PDN) for routing signals provided to semiconductor devices on the back of the substrate.

### SUMMARY

Some aspects of the present disclosure provide semiconductor devices with improved reliability. It will be understood that the technical effects of and improvements provided by this disclosure are not limited thereto, and that others will be clearly understood by those skilled in the art from the description below.

A semiconductor device according to some implementations of the present disclosure includes a base insulating layer comprising an upper surface and a lower surface opposing one another, a channel structure on the upper surface of the base insulating layer, a gate structure surrounding the channel structure, source/drain patterns on the upper surface of the base insulating layer and connected to the channel structure, power rails on the lower surface of the base insulating layer, and one or more lower contact electrodes connecting one or more of the power rails to one or more of the source/drain patterns, wherein a lower surface of a first lower contact electrode of the one or more lower contact electrodes is positioned at a level higher than the lower surface of the base insulating layer.

A semiconductor device according to some implementations of the present disclosure includes a base insulating layer comprising an upper surface and a lower surface opposing one another, a channel structure on the upper surface of the base insulating layer, a gate structure surrounding the channel structure, source/drain patterns on the upper surface of the base insulating layer and connected to the channel structure, a first lower insulating layer on the lower surface of the base insulating layer, a second lower insulating layer between the first lower insulating layer and the base insulating layer, a lower contact electrode connected to the source/drain pattern, and a power rail extending in the first lower insulating layer and the second lower insulating layer, wherein the power rail is connected to the lower contact electrode, wherein the power rail includes a first portion overlapping the first lower insulating layer along a horizontal direction, and a second portion overlapping the second lower insulating layer along the horizontal direction, and wherein a smallest width of the first portion in the horizontal direction is greater than a greatest width of the second portion in the horizontal direction. According to some implementations of the semiconductor device, a lower surface of the lower contact electrode is positioned at a same level as the lower surface of the base insulating layer. According to some implementations of the semiconductor device, the semiconductor device comprises an insulating liner between the first lower insulating layer and the second lower insulating layer, wherein a side surface of the first portion of the power rail is in contact with the insulating liner. According to some implementations of the semiconductor device an upper surface of the first portion of the power rail is in contact with a lower surface of the second lower insulating layer.

A semiconductor device according to some implementations of the present disclosure includes a base insulating layer comprising an upper surface and a lower surface, a channel structure on the upper surface of the base insulating layer, wherein the channel structure comprises a plurality of channel patterns spaced apart from the upper surface of the base insulating layer in a vertical direction, a gate structure surrounding each of the plurality of channel patterns, first and second source/drain patterns spaced apart from one another in a horizontal direction, wherein the channel structure is between the first and second source/drain patterns, wherein the first and second source/drain patterns are connected to the plurality of channel patterns, and wherein the horizontal direction is parallel to the upper surface of the base insulating layer, a barrier layer between the first and second source/drain patterns and the base insulating layer, and between the gate structure and the base insulating layer, an insulating liner on the lower surface of the base insulating layer, a first lower insulating layer on a lower surface of the insulating liner, a lower contact electrode extending through the barrier layer, wherein the lower contact electrode is connected to a lower portion of at least one of the first and second source/drain patterns, and wherein the lower contact electrode extends in the base insulating layer and a power rail extending in the first lower insulating layer and the insulating liner, wherein the power rail is in contact with a lower surface of the lower contact electrode, wherein a surface of the power rail that is in contact with the lower surface of the lower contact electrode is positioned at a level higher than the lower surface of the base insulating layer, wherein the power rail includes a first portion overlapping the first lower insulating layer and the insulating liner along the horizontal direction and a second portion overlapping the base insulating layer along the horizontal direction, and wherein a smallest width of the first portion in the horizontal direction is greater than a greatest width of the second portion in the horizontal direction.

A method for manufacturing a semiconductor device according to some implementations of the present disclosure includes forming a channel structure on a substrate, forming a gate structure surrounding the channel structure, forming source/drain patterns on opposite sides of the channel structure, removing the substrate and filling the portion from which the substrate was removed with insulating material to form a base insulating layer, forming a lower contact electrode having one end connected to at least one of the source/drain patterns, and forming a power rail connected to the other end of the lower contact electrode, wherein the lower surface of the lower contact electrode is positioned at a higher level than the lower surface of the base insulating layer. may

In some implementations of the method for manufacturing the semiconductor device, the forming the lower contact electrode includes etching a portion of the base insulating layer that overlaps with the source/drain pattern to form a trench, forming a lower contact electrode material layer inside the trench and on the lower surface of the base insulating layer, and etching a portion of the lower region of the lower contact electrode material layer, wherein in the step of etching the portion of the lower region of the lower contact electrode material layer, the portion of the lower region of the lower contact electrode material layer positioned at a level higher than the lower surface of the base insulating layer may be etched.

In some implementations of the method for manufacturing a semiconductor device, the power rail includes a first portion positioned at a level lower than the bottom surface of the base insulating layer and a second portion positioned at a level higher than the bottom surface of the base insulating layer, and the minimum width in the horizontal direction of the first portion may be wider than the maximum width in the horizontal direction of the second portion.

In some implementations of the semiconductor device manufacturing method, forming the power rail includes forming a first lower insulating layer on the lower surface of the base insulating layer, etching a portion of the region of the first lower insulating layer that overlaps with the lower contact electrode, and filling the etched region with a conductive material, wherein at least a portion of the side surface of the first portion is surrounded by the first lower insulating layer, and at least a portion of the side surface of the second portion may be surrounded by the base insulating layer.

In some implementations of the method for manufacturing the semiconductor device, the method further includes forming a second lower insulating layer between the base insulating layer and the first lower insulating layer, and at least a portion of a side surface of the second portion may be surrounded by the second lower insulating layer.

In some implementations of the method for manufacturing the semiconductor device, the first lower insulating layer and the second lower insulating layer may include different insulating materials.

In some implementations of the method for manufacturing semiconductor device, the second lower insulating layer may include a material having a lower dielectric constant than the dielectric constant of silicon oxide (SiO₂).

Based on the description provided herein, semiconductor devices having improved reliability may be provided.

### BRIEF DESCRIPTION OF THE DRAWINGS

FIG. 1 is a plan view showing an example of a semiconductor device.
FIG. 2 is a cross-sectional view along line I1-I1' of FIG. 1.
FIG. 3 is a cross-sectional view along line I2-I2' of FIG. 1.
FIG. 4 is a cross-sectional view along line I3-I3' of FIG. 1.
FIG. 5 is an enlarged cross-sectional view of area 'A' of FIG. 2.
FIG. 6 is a cross-sectional view of an example of a semiconductor device along line I1-I1' of FIG. 1.
FIG. 7 is an enlarged cross-sectional view of area 'B' of FIG. 6.
FIG. 8 is a cross-sectional view of an example of a semiconductor device along line I1-I1' of FIG. 1.
FIG. 9 is a cross-sectional view of an example of a semiconductor device along line I1-I1' of FIG. 1.
FIG. 10 is a cross-sectional view of an example of a semiconductor device along line I1-I1' of FIG. 1.
FIG. 11 is a cross-sectional view of an example of a semiconductor device along line I1-I1' of FIG. 1.
FIG. 12 to FIG. 31 are drawings illustrating an example of a method for manufacturing a semiconductor device.

### DETAILED DESCRIPTION

The present disclosure will be described more fully hereinafter with reference to the accompanying drawings, in which examples are shown. As those skilled in the art would realize, the described examples may be modified in various different ways, all without departing from the spirit or scope of the present disclosure.

Descriptions of parts not related to the present disclosure may be omitted, and like reference numerals designate like elements throughout the specification.

Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., may be exaggerated for clarity.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" refers to a relative positioning, and need not be based on a gravitational direction.

In addition, unless explicitly described to the contrary, the word "comprise", and variations such as "comprises" or "comprising", will be understood to imply the inclusion of stated elements but not the exclusion of any other elements.

Further, in the specification, the phrase "on a plane" or "in a plan view" means when an object portion is viewed from above, and the phrase "on a cross-section" means when a cross-section taken by vertically cutting an object portion is viewed from the side.

In drawings of semiconductor devices provide herein, GAA (Gate All Around) and MBCFET^{™} (Multi-Bridge Channel Field Effect Transistor) including nano wires or nano sheets are illustrated as examples, but the types of semiconductor devices within the scope of this disclosure are not limited thereto. For example, the semiconductor device may include a fin-type transistor (FinFET) including a channel structure in a fin-type pattern shape, a tunneling transistor (tunneling FET), a 3D-SFET (3D Stack Field Effect Transistor) structure, and/or a CFET (Complementary Field Effect Transistor) structure.

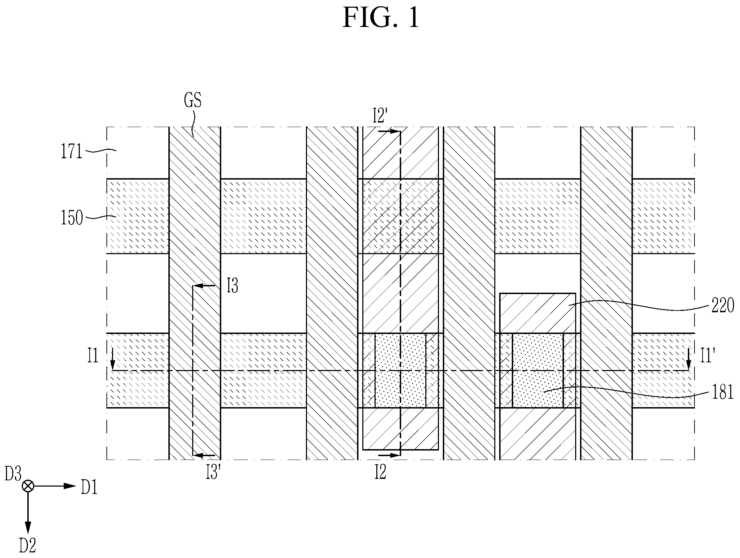

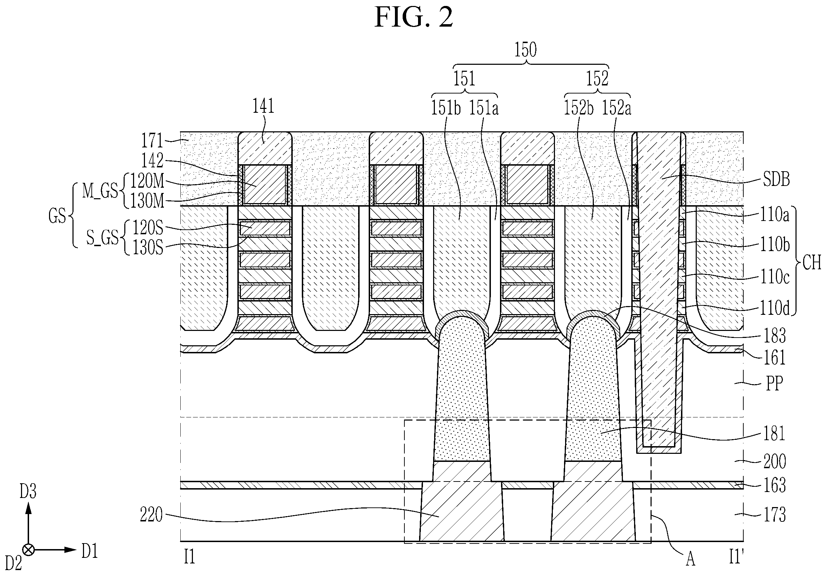

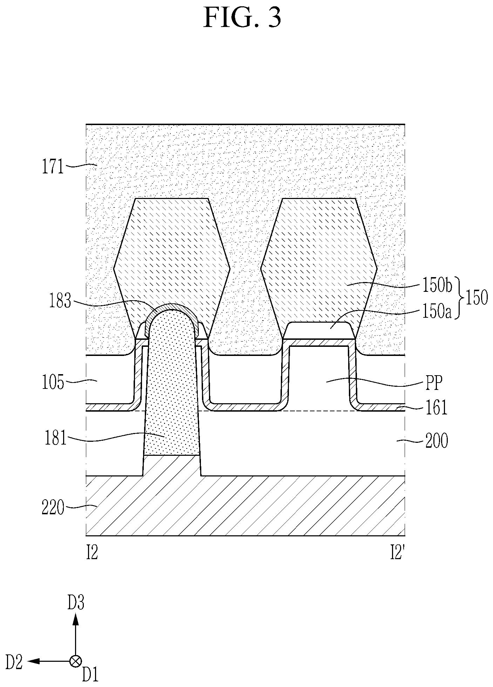

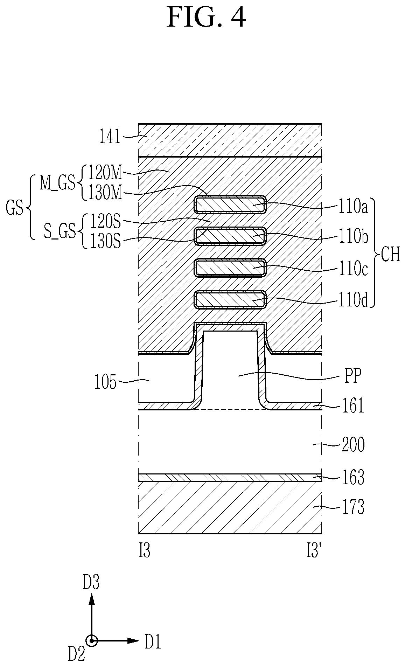

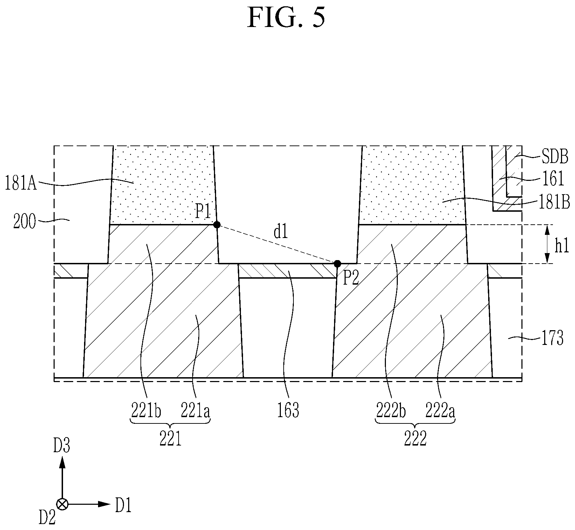

FIG. 1 is a plan view showing an example of a semiconductor device, FIG. 2 is a cross-sectional view of the semiconductor device along line I1-I1' of FIG. 1, FIG. 3 is a cross-sectional view of the semiconductor device along line I2-I2' of FIG. 1, FIG. 4 is a cross-sectional view of the semiconductor device along line I3-I3' of FIG. 1, and FIG. 5 is an enlarged cross-sectional view of area 'A' of FIG. 2. FIG. 1 illustrates a planar shape of a semiconductor device when viewed in a third direction D3 from below a first lower insulating layer 173 described below.

Referring to FIG. 1 to FIG. 5, a semiconductor device may include a base insulating layer 200, a channel structure CH positioned on the base insulating layer 200, a gate structure GS surrounding the channel structure CH, source/drain patterns 150 positioned on the base insulating layer 200 and connected to opposite sides of the channel structure CH, power rails 220 positioned below the base insulating layer 200, and a lower contact electrode 181 connecting at least one of the power rails 220 and at least one of the source/drain patterns 150.

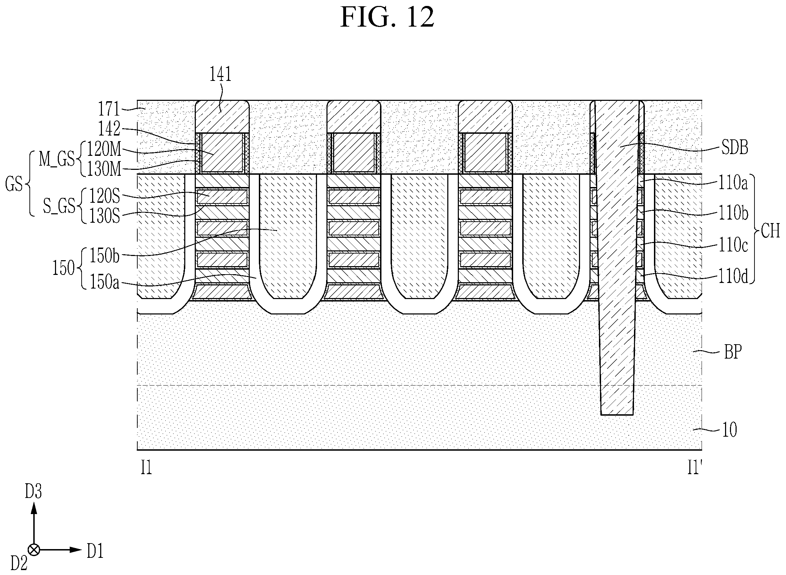

The base insulating layer 200 may be an insulating substrate. The base insulating layer 200 may include an oxide, a nitride, an oxynitride, or a combination thereof. For example, the base insulating layer 200 may include silicon oxide (SiO₂). The base insulating layer 200 is illustrated as a single film, but this is only for convenience of explanation, and the number of films is not limited thereto. The base insulating layer 200 may be formed by etching a substrate 10 (see FIG. 12), and then filling the etched portion with an insulating material.

The first surface and the second surface of the base insulating layer 200 may be formed as planes parallel to a first direction D1 and a second direction D2 intersecting the first direction D1. For example, the first surface of the base insulating layer 200 may be the upper surface, and the second surface may be the lower surface. The upper surface of the base insulating layer 200 may be a surface opposite the lower surface of the base insulating layer 200 in the third direction D3. The third direction D3 may be a direction perpendicular to the first direction D1 and the second direction D2. The lower surface of the base insulating layer 200 may be referred to as the back side of the base insulating layer 200. In some implementations, the logic circuitry of the cell region may be implemented on the upper surface of the base insulating layer 200.

The semiconductor device may further include protrusion patterns PP positioned on the base insulating layer 200. The protrusion patterns PP may be portions that protrude in the third direction D3 from the first surface of the base insulating layer 200. The protrusion patterns PP may be formed by etching a lower pattern BP (see FIG. 12), and then filling the etched portion with an insulating material.

The protrusion patterns PP may extend in the first direction D1. The protrusion patterns PP may be arranged spaced apart in the second direction D2 on the first surface of the base insulating layer 200. The source/drain patterns 150 may be positioned on the protrusion patterns PP. The source/drain patterns 150 may be arranged spaced apart in the first direction D1 on each of the protrusion patterns PP.

The protrusion patterns PP may include an insulating material. The protrusion patterns PP may include silicon oxide (SiO₂), silicon nitride (SiN_{X}), silicon oxynitride (SiON), or a combination thereof. In some implementations, the protrusion patterns PP may comprise the same material as the base insulating layer 200. In some implementations, the protrusion pattern PP and the base insulating layer 200 may be formed integrally. In this case, the boundary between the protrusion pattern PP and the base insulating layer 200 may not be recognized.

The channel structures CH may be positioned on the first surface of the base insulating layer 200. As shown in FIG. 2 and FIG. 3, when a protrusion pattern PP is positioned on a base insulating layer 200, the channel structures CH may be positioned on the protrusion pattern PP. The channel structures CH may be arranged spaced apart in the first direction D1 on the base insulating layer 200 and/or the protrusion pattern PP. Each of the channel structures CH may include a first channel pattern 110a, a second channel pattern 110b, a third channel pattern 110c, and a fourth channel pattern 110d. A plurality of channel patterns 110a, 110b, 110c, 110d may be arranged spaced apart from each other in a third direction D3. For example, each of the plurality of channel patterns 110a, 110b, 110c, 110d may have a sheet shape. Each of the channel patterns 110a, 110b, 110c, 110d may be a nanosheet having a thickness of several nanometers along the third direction D3.

The channel structures CH may provide a path for current to flow between source/drain patterns 150, as to be described later. Referring to FIG. 2 and FIG. 3, channel structures CH may be arranged between source/drain patterns 150 and connect the source/drain patterns 150 to each other. The channel structures CH may penetrate a portion of the gate structure GS in a direction (e.g., a first direction D1) that intersects the direction in which the gate structure GS extends. In FIG. 2 and FIG. 4, the channel structures CH are illustrated as having four channel patterns 110a, 110b, 110c, 110d arranged spaced apart in the third direction D3, but the number of channel patterns is not limited thereto, and the number of stacked channel patterns 110a, 110b, 110c, 110d included in one channel structure CH may vary.

The channel structures CH may include a semiconductor material. For example, the material(s) of the channel structures CH may include group IV semiconductors such as Si, Ge, group III-V compound semiconductors, group II-VI compound semiconductors, etc. In some implementations, a protrusion pattern PP may be positioned below the channel structure CH. For example, the protrusion pattern PP may be located between a sub-gate structure S_GS located at the lowermost position among the plurality of sub-gate structures S_GS (to be described later), and the base insulating layer 200. The upper surface of the protrusion pattern PP may be in contact with the lower surface of the sub-gate structure S_GS located at the lowest position among the plurality of sub-gate structures S_GS.

As some implementations, unlike those illustrated in FIG. 2 to FIG. 4, the semiconductor device may not include a protrusion pattern PP. In this case, the lower surface of the sub-gate structure S_GS located at the lowest position among the sub-gate structures S_GS may directly contact the base insulating layer 200.

The semiconductor device may further include a field insulating layer 105 positioned over the base insulating layer 200. The field insulating layer 105 may be positioned between two protrusion patterns PP adjacent in the second direction D2. The field insulating layer 105 may not be located on the upper surface of the protrusion pattern PP.

The field insulating layer 105 may be positioned on the upper surface of the base insulating layer 200 and the side surfaces of the protrusion patterns PP. The field insulating layer 105 may entirely cover the side surface of the protrusion pattern PP. In some implementations, the field insulating layer 105 may cover only a portion of the side surface of the protrusion pattern PP. In such a case, a portion of the protrusion pattern PP may protrude further in the third direction D3 than the upper surface of the field insulating layer 105.

In some implementations, a barrier layer 161 may be positioned between the side surface of the field insulating layer 105 and the protrusion pattern PP, and between the lower surface of the field insulating layer 105 and the base insulating layer 200.

The field insulating layer 105 may include, for example, an oxide, a nitride, an oxynitride, or a combination thereof. The field insulating layer 105 is illustrated as a single film, but this is only for convenience of explanation, and the film number is not limited thereto.

The gate structure GS may be positioned on the base insulating layer 200. A protrusion pattern PP or field insulating layer 105 may be positioned between the gate structure GS and the base insulating layer 200. The gate structure GS may extend in a direction different from the direction in which the protrusion pattern PP extends on the base insulating layer 200. For example, the gate structure GS may extend in a direction that intersects the direction in which the protrusion pattern PP extends on the base insulating layer 200 (e.g., a second direction D2). The gate structure GS may be positioned on the base insulating layer 200. The gate structure GS may be arranged spaced apart from each other in the first direction D1. The gate structure GS may include a sub-gate structure S_GS and a main gate structure M_GS. The sub-gate structure S_GS may be positioned on the base insulating layer 200, and the main gate structure M_GS may be positioned on the sub-gate structure S_GS. As shown in the cross-sectional view in FIG. 4, the main gate structure M_GS may also be positioned on the field insulating layer 105. A side surface of the sub-gate structure S_GS may be covered by a portion of the main gate structure M_GS positioned on the field insulating layer 105. A sub-gate structure S_GS may not be located on the field insulating layer 105. For example, the sub-gate structure S_GS may not be located between the main gate structure M_GS and the field insulating layer 105.

Each of the sub-gate structures S_GS may be composed of multiple layers. For example, each of the sub-gate structures S_GS may include a sub-gate electrode 120S and a sub-gate insulating layer 130S. Sub-gate structures S_GS and channel patterns 110a, 110b, 110c, 110d may be alternately stacked in a third direction D3. In FIG. 2 and FIG. 4, four sub-gate structures S_GS are depicted as being arranged spaced apart in the third direction D3, but the number of sub-gate structures S_GS arranged spaced apart is not limited thereto. For example, a gate structure GS may include three sub-gate structures S_GS.

The sub-gate electrode 120S may be positioned on the protrusion pattern PP. A plurality of sub-gate electrodes 120S may be positioned spaced apart from each other on the protrusion pattern PP. A plurality of sub-gate electrodes 120S and a plurality of channel patterns 110a, 110b, 110c, 110d may be alternately and repeatedly laminated. At least one of the upper and lower surfaces of the plurality of channel patterns 110a, 110b, 110c, 110d may be covered by a sub-gate electrode 120S. For example, the lower surface of the first channel pattern 110a may be covered by a sub-gate electrode 120S, and the upper surface of the fourth channel pattern 110d may be covered by a sub-gate electrode 120S. The upper and lower surfaces of each of the second channel pattern 110b and the third channel pattern 110c may be covered by a sub-gate electrode 120S.

The sub-gate electrode 120S may include at least one of a metal, a metal alloy, a conductive metal nitride, a metal silicide, a doped semiconductor material, a conductive metal oxide, and a conductive metal oxynitride. The sub-gate electrode 120S may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbide nitride (TiAIC-N), titanium aluminum carbide (TiAlC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but is not limited thereto. The conductive metal oxides and the conductive metal oxynitrides may include oxidized forms of the aforementioned materials but are not limited thereto.

The sub-gate insulating layer 130S may extend along the upper surface of the barrier layer 161 described later. The sub-gate insulating layer 130S may be positioned along the perimeter of a plurality of channel patterns 110a, 110b, 110c, 110d. The sub-gate insulating layer 130S may be in direct contact with the barrier layer 161 and a plurality of channel patterns 110a, 110b, 110c, 110d. A sub-gate insulating layer 130S may be interposed between a plurality of channel patterns 110a, 110b, 110c, 110d and a sub-gate electrode 120S. The sub-gate insulating layer 130S may include various insulating materials. The semiconductor device may further include an inner gate spacer positioned between the sub-gate insulating layer 130S and the source/drain pattern 150.

The sub-gate insulating layer 130S is illustrated as a single film, but is not limited thereto. For example, the sub-gate insulating layer 130S may be formed of a multi-film including silicon oxide (SiO₂) and a high-k material. The high-k material may include a material having a higher dielectric constant than silicon oxide (SiO₂), such as hafnium oxide (HfO), aluminum oxide (AlO), or tantalum oxide (TaO).

The main gate structure M_GS may be positioned on the sub-gate structure S_GS and a plurality of channel patterns 110a, 110b, 110c, 110d. The main gate structure M_GS may be positioned on the surface of the uppermost channel pattern 110a among the plurality of channel patterns 110a, 110b, 110c, 110d. The main gate structure M_GS may also be on the field insulating layer 105. The main gate structure M_GS may cover opposite side surfaces of the sub-gate structure S_GS.

The main gate structure M_GS may include a main gate electrode 120M and a main gate insulating layer 130M.

The main gate electrode 120M may be positioned on the sub-gate structure S_GS and a plurality of channel patterns 110a, 110b, 110c, 110d. The main gate electrode 120M may extend in a direction intersecting the protrusion pattern PP. At least a portion of the main gate electrode 120M may be positioned on a structure in which a sub-gate electrode 120S and a plurality of channel patterns 110a, 110b, 110c, 110d are alternately stacked. The remaining portion of the main gate electrode 120M may cover the side surface of the structure in which the sub-gate electrode 120S and a plurality of channel patterns 110a, 110b, 110c, 110d are alternately stacked. Each of the four side surfaces of the plurality of channel patterns 110a, 110b, 110c, 110d may be surrounded by a sub-gate electrode 120S and/or a main gate electrode 120M.

The main gate electrode 120M may include the same material as the sub-gate electrode 120S. For example, the main gate electrode 120M may include at least one of a metal, a metal alloy, a conductive metal nitride, a metal silicide, a doped semiconductor material, a conductive metal oxide, and a conductive metal oxynitride.

The main gate insulating layer 130M may extend along the side surface of the main gate electrode 120M. The main gate insulating layer 130M may extend along the side surface of the gate spacer 142 described later. The main gate insulating layer 130M may include various insulating materials. The main gate insulating layer 130M may include the same material as the sub-gate insulating layer 130S.

The main gate insulating layer 130M is illustrated as a single film, but is not limited thereto. For example, the main gate insulating layer 130M may be formed of a multi-film including silicon oxide (SiO₂) and a high-k material. The high-k material may include a material having a higher dielectric constant than silicon oxide (SiO₂), such as hafnium oxide (HfO), aluminum oxide (AlO), or tantalum oxide (TaO).

The semiconductor device may further include a capping layer 141 and a gate spacer 142.

The gate spacer 142 may be positioned on the side surface of the main gate electrode 120M. The gate spacer 142 may be positioned over a channel structure CH. The gate spacer 142 may not be located on the side surface of the sub-gate electrode 120S. The gate spacer 142 may not be located on the side surface of Each of the channel patterns 110a, 110b, 110c, 110d. The gate spacer 142 may not be disposed between the protrusion pattern PP and the plurality of channel patterns 110a, 110b, 110c, 110d. The gate spacer 142 may not be positioned between a plurality of channel patterns 110a, 110b, 110c, 110d adjacent to each other in the third direction D3. The gate spacer 142 is illustrated as a single film, but this is only for convenience of explanation, and the film number is not limited thereto.

The gate spacer 142 may include, for example, at least one of silicon nitride (SiN_{X}), silicon oxynitride (SiON), silicon oxide (SiO₂), silicon carbonitride (SiOCN), silicon boron nitride (SiBN), silicon oxyboron nitride (SiOBN), silicon oxycarbide (SiOC), or a combination thereof. The gate spacer 142 is illustrated as a single film, but this is only for convenience of explanation, and the film number is not limited thereto.

The capping layer 141 may be positioned on the main gate structure M_GS and the gate spacer 142. The upper surface and side surfaces of the capping layer 141 may be covered by an interlayer insulating layer 171. In some implementations, the capping layer 141 is also located between the gate spacers 142.

The capping layer 141 may include, for example, at least one of silicon nitride (SiN), silicon oxynitride (SiON), silicon carbonitride (SiCN), silicon oxycarbonitride (SiOCN), or a combination thereof. The capping layer 141 may include a material having an etching selectivity with respect to the interlayer insulating layer 171.

The source/drain patterns 150 may be positioned on the base insulating layer 200. A protrusion pattern PP may be positioned between the source/drain patterns 150 and the base insulating layer 200. However, the arrangement of the protrusion pattern PP is not limited thereto, and a protrusion pattern PP may not be located between the source/drain pattern 150 and the base insulating layer 200. A channel structure CH and a gate structure GS may be positioned between the source/drain patterns 150. For example, a plurality of source/drain patterns 150 and a plurality of channel structures CH may be alternately arranged along the first direction D1 in which the protrusion pattern PP extends.

The source/drain patterns 150 may also be arranged in the second direction D2. For example, a plurality of protrusion patterns PP may be arranged spaced apart from each other along the second direction D2 on the base insulating layer 200, and the source/drain patterns 150 may be positioned on each of the protrusion patterns PP. The source/drain pattern 150 may be located on opposite sides of the channel structure CH or the sub-gate structure S_GS. For example, two source/drain patterns 150 positioned on one protrusion pattern PP may be arranged spaced apart in a direction intersecting the direction in which the gate structure GS extends (e.g., a first direction D1), with a channel structure CH or a sub-gate structure S_GS therebetween. The source/drain pattern 150 may be in direct contact with the channel structure CH or the sub-gate structure S_GS. The source/drain pattern 150 may be in direct contact with the sub-gate insulating layer 130S of the sub-gate structure S_GS. An inner spacer may be additionally placed between the source/drain pattern 150 and the sub-gate insulating layer 130S. The inner spacer may include at least one of silicon nitride (SiNx), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), or a combination thereof.

The source/drain pattern 150 may be composed of an epitaxial layer formed by selective epitaxial growth (SEG). For example, the source/drain patterns 150 may be formed by removing at least a portion of a semiconductor pattern stacked on a protrusion pattern PP, and selectively growing a semiconductor material in the corresponding region by using a selective epitaxial growth (SEG) method.

The source/drain patterns 150 may each include a liner layer 150a and a filling layer 150b. The liner layer 150a may be located on the outer side surface of the filling layer 150b. The side surface and lower surface of the filling layer 150b may be surrounded by a liner layer 150a. The liner layer 150a may be in direct contact with the sub-gate structure S_GS and the channel structure CH. The filling layer 150b may be positioned on the liner layer 150a. The filling layer 150b and the liner layer 150a may have upper surfaces of substantially the same height. However, the surface arrangement is not limited thereto, and, unlike what is illustrated in FIG. 2, the filling layer 150b and the liner layer 150a may have upper surfaces of different heights in some areas.

The semiconductor device may include a first source/drain pattern 151 and a second source/drain pattern 152 adjacent to each other. The first source/drain pattern 151 and the second source/drain pattern 152 may each include a filling layer 151b, 152b and a liner layer 151a, 152a. In some implementations, two adjacent source/drain patterns 151, 152 may each be connected to different power rails 220.

The source/drain pattern 150 may include a semiconductor material. The source/drain pattern 150 may include, for example, silicon (Si) or germanium (Ge). Additionally, the source/drain pattern 150 may include a binary compound or a ternary compound including at least two or more of, for example, carbon (C), silicon (Si), germanium (Ge), and tin (Sn). For example, the source/drain pattern 150 may include, silicon (Si), silicon-germanium (SiGe), germanium (Ge), silicon carbide (SiC), and the like, but is not limited thereto. In some implementations, the liner layer 150a and the filling layer 150b may have different germanium (Ge) concentrations to each other. For example, the concentration of germanium (Ge) included in the liner layer 150a may be lower than the concentration of germanium (Ge) included in the filling layer 150b.

The semiconductor device may further include a separating structure SDB positioned on one side of the source/drain pattern 150. A separating structure SDB may physically separate adjacent source/drain patterns 150.

The separating structure SDB may penetrate the capping layer 141 and the gate structure GS in the third direction D3. The separating structure SDB may penetrate the channel structure CH in a third direction D3. The width along the first direction D1 of the separating structure SDB may be smaller than or substantially equal to the width of the gate structure GS. For example, when the width along the first direction D1 of the separating structure SDB is smaller than the width of the gate structure GS, non-removed gate structure GS may be located around the separating structure SDB. For example, the same material as the gate structure GS may be positioned to contact the outside of the separating structure SDB. For example, when the width along the first direction D1 of the separating structure SDB is substantially the same as the width of the gate structure GS, the separating structure SDB may be in contact with the first interlayer insulating layer 171 to be described later.

The upper surface of the separating structure SDB may be positioned at substantially the same level as the upper surface of the capping layer 141. The separating structure SDB may extend into the interior of the base insulating layer 200. The separating structure SDB may penetrate the protrusion pattern PP in the third direction D3. The lower surface of the separating structure SDB may be located between the upper surface and the lower surface of the base insulating layer 200. A portion of the separating structure SDB located at a lower level than the lower surface of the gate structure GS may be surrounded by a barrier layer 161 to be described later.

The separating structure SDB may include an insulating material. For example, the separating structure SDB may include, at least one of silicon oxide (SiO₂), silicon nitride (SiNx), and silicon oxynitride (SiON), but is not limited thereto.

The semiconductor device may further include a barrier layer 161 positioned between the gate structure GS and the base insulating layer 200, and/or between the source/drain pattern 150 and the base insulating layer 200.

When the semiconductor device includes a protrusion pattern PP as illustrated in FIG. 2 to FIG. 5, the barrier layer 161 may also be positioned between the protrusion pattern PP and the gate structure GS, and/or between the protrusion pattern PP and the source/drain pattern 150. The barrier layer 161 may extend along a portion of the upper surface of the base insulating layer 200 and the profile of the upper surface and side surfaces of the protrusion pattern PP. For example, the barrier layer 161 may cover the entire upper surface and entire side surface of the protrusion pattern PP. The barrier layer 161 may cover an area of the entire upper surface of the base insulating layer 200 that does not overlap with the protrusion pattern PP in the thickness direction. The barrier layer 161 may cover a region of the entire upper surface of the base insulating layer 200 that does not overlap with the protrusion pattern PP in a thickness direction. In some implementations, the barrier layer 161 may surround the side surface and lower surfaces of the separating structure SDB located at a lower level than the bottom surface of the gate structure GS.

The barrier layer 161 may be positioned on the lower surface of the gate structure GS. The barrier layer 161 may cover at least a portion of the lower surface of the source/drain pattern 150. The barrier layer 161 may be in contact with the lower surface of the gate structure GS in a region overlapping the gate structure GS in the thickness direction. The barrier layer 161 may be in contact with the lower surface of the source/drain pattern 150 or the lower surface of the field insulating layer 105 in an area that does not overlap with the gate structure GS in the thickness direction.

The barrier layer 161 may include an insulating material. The barrier layer 161 may be selected from among various insulating materials as a material suitable for preventing impurities included in the base insulating layer 200, such as oxygen ions or oxygen molecules, from penetrating into the gate structure GS. For example, the barrier layer 161 may include at least one of silicon nitride (SiNx) and silicon carbon nitride (SiCxNy).

The barrier layer 161 may be configured to reduce or prevent damage to the source/drain pattern 150 during etching of the base insulating layer 200 for formation of the lower contact electrode 181. As another example, the barrier layer 161 may be configured to reduce or prevent a material included in the base insulating layer 200 and/or the protrusion pattern PP from penetrating into the gate structure GS. For example, when the base insulating layer 200 and the protrusion pattern PP include silicon oxide (SiO₂), oxygen ions or oxygen molecules included in the base insulating layer 200 and the protrusion pattern PP may penetrate into the gate structure GS, causing a threshold voltage of the semiconductor device to shift. The barrier layer 161 may be positioned between the lower surface of the gate structure GS and the upper surface of the base insulating layer 200 and/or the protrusion pattern PP, and may prevent impurities, such as oxygen, included in the base insulating layer 200 from penetrating into the gate structure GS.

The semiconductor device may further include an interlayer insulating layer 171 covering the source/drain pattern 150 and the gate structure GS. The interlayer insulating layer 171 may also be positioned on the side surface of the gate spacer 142 and the side surface of the capping layer 141. In some implementations, the interlayer insulating layer 171 may also be positioned on the upper surface of the capping layer 141.

An interlayer insulating layer 171 may be positioned on the upper surface of the source/drain patterns 150. The interlayer insulating layer 171 may also be located over a portion of the side surface of the source/drain pattern 150. The interlayer insulating layer 171 may cover the entire upper surface and entire side surface of the source/drain patterns 150 in an area that does not overlap with the gate structure GS in the third direction D3. The interlayer insulating layer 171 may also be positioned on the upper surface of the field insulating layer 105.

The interlayer insulating layer 171 may include, for example, at least one of silicon oxide (SiO₂), silicon nitride (SiN_{X}), silicon oxynitride (SiON), and a low-k material (i.e., a material having a low dielectric constant). Iow-k materials may include, for example, one of Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate) Glass), SiLK, amorphous fluorinated carbon, silica aerogels, silica xerogels, mesoporous silica or a combination thereof, but is not limited thereto. In some implementations, the interlayer insulating layer 171 and the field insulating layer 105 may include different insulating materials to each other. However, the materials are not limited to this, and in some implementations, the interlayer insulating layer 171 and the field insulating layer 105 may include the same insulating material.

The semiconductor device may further include a first lower insulating layer 173 positioned below the base insulating layer 200. The first lower insulating layer 173 may electrically isolate a power rail 220 from another adjacent power rail 220. The first lower insulating layer 173 may surround at least a portion of the side surface of the power rail 220. The first lower insulating layer 173 may surround at least a portion of a side surface of the power rail 220 located at a level lower than the lower surface of the base insulating layer 200.

The first lower insulating layer 173 may include an insulating material. For example, the first lower insulating layer 173 may include at least one of silicon oxide (SiO₂), silicon nitride (SiN_{X}), and silicon oxynitride (SiON), but is not limited thereto.

The semiconductor device may further include an insulating liner 163 positioned between the base insulating layer 200 and the first lower insulating layer 173. The insulating liner 163 may function as an etching stop layer during the process of etching a portion of the first lower insulating layer 173 to form a power rail 220, to be described later. The insulating liner 163 may surround at least a portion of a side surface of the power rail 220. The insulating liner 163 may surround at least a portion of a side surface of the power rail 220 located at a level lower than the lower surface of the base insulating layer 200 and higher than the upper surface of the first lower insulating layer 173.

The insulating liner 163 may include an insulating material. For example, the insulating liner 163 may include at least one of silicon oxide (SiO₂), silicon nitride (SiNx), or silicon oxynitride (SiON), but is not limited thereto.

The lower contact electrode 181 may be connected to the lower portion of the source/drain pattern 150. The lower contact electrode 181 may be located between the power rail 220 and the source/drain pattern 150, to be described later. The lower contact electrode 181 may electrically connect at least one of the power rails 220 and at least one of the source/drain patterns 150. The lower contact electrode 181 may transmit power provided from the power rail 220 to the source/drain pattern 150.

The lower contact electrode 181 may penetrate the protrusion pattern PP and the barrier layer 161 in the third direction D3. One end of the lower contact electrode 181 may be recessed into the interior of the source/drain pattern 150. Accordingly, the lower contact electrode 181 may be in contact with a portion of the source/drain pattern 150.

The other end of the lower contact electrode 181 may extend into the interior of the base insulating layer 200. In some implementations, at least a portion of the side surface of the lower contact electrode 181 may be surrounded by a base insulating layer 200, or a protrusion pattern PP. The lower contact electrode 181 may have a side surface that is in contact with the protrusion pattern PP or the base insulating layer 200 in an area that does not horizontally overlap with the source/drain pattern 150. One end of the lower contact electrode 181 may penetrate at least a portion of the barrier layer 161 and be connected to the source/drain pattern 150.

In some implementations, the lower surface of the lower contact electrode 181 may be positioned at a higher level than the lower surface of the base insulating layer 200. For example, in the process of forming the lower contact electrode 181, a portion of the lower region of the lower contact electrode 181 may be removed, and thus, the lower surface of the lower contact electrode 181 may be positioned at a higher level than the lower surface of the base insulating layer 200. Referring to FIG. 5, the difference h1 between the level at which the lower surface of the lower contact electrode 181 is located and the level at which the lower surface of the base insulating layer 200 is located may be greater than 0 and less than about 8 nm. In some implementations, the lower surface of the lower contact electrode 181 may be positioned at a lower level than the lower surface of the separating structure SDB.

The lower contact electrode 181 may have an inclined side surface where the width in the horizontal direction (e.g., the first direction D1 or the second direction D2) gradually increases as it approaches the lower surface of the base insulating layer 200 depending on the aspect ratio, but is not limited thereto.

The lower contact electrode 181 may include a conductive material. The lower contact electrode 181 may include at least one of a metal, a metal alloy, a conductive metal nitride, a conductive metal carbide, a conductive metal oxide, a conductive metal carbonitride, or a two-dimensional (2D) material. The metal may include at least one of copper (Cu), titanium (Ti), tantalum (Ta), tungsten (W), nickel (Ni), cobalt (Co), and platinum (Pt). The conductive metal nitride may include at least one of titanium nitride (TiN), tantalum nitride (TaN), tungsten nitride (WN), nickel nitride (NiN), cobalt nitride (CoN), or platinum nitride (PtN).

In some implementations, the lower contact electrode 181 may include a metal that is not easily etched. For example, the lower contact electrode 181 may include at least one of copper (Cu), tungsten (W), or cobalt (Co). However, the material is not limited thereto, and the lower contact electrode 181 may include various conductive materials.

The semiconductor device may further include a silicide layer 183 positioned between the source/drain pattern 150 and the lower contact electrode 181. The silicide layer 183 may extend along at least a portion of the side surface and upper surface of the lower contact electrode 181.

The power rails 220 may be located below the base insulating layer 200. The power rails 220 may supply power to the semiconductor device. The semiconductor device may include a plurality of power rails 220 extending in one direction. Referring to FIG. 1 to FIG. 3, each of the power rails 220 may extend in a direction parallel to the direction in which the gate structure GS extends. For example, referring to FIG. 1, the power rails 220 may extend in the second direction D2. For example, a plurality of power rails 220 may be positioned spaced apart from each other in the first direction D1. In some implementations, the power rails 220 may extend in a direction intersecting the direction in which the gate structure GS extends (e.g., the first direction D1).

FIG. 1 illustrates only a portion of the power rails 220. In FIG. 1, the power rails 220 are depicted as extending along the second direction D2, but the power rails 220 may also include a portion extending in the first direction D1. For example, each power rail illustrated in FIG. 1 may be a sub-region of a power rail 220 that extends along the second direction D2 from the side surface of the main region of a power rail 220 that extends in the first direction D1.

In some implementations, each of the power rails 220 may be connected to an external power source. For example, a power rail 220 may be connected to an external input power source to provide power to the semiconductor device. For example, a power rail 220 may be connected to ground. For example, some of the multiple power rails 220 may be connected to the input power, and some may be connected to ground. For example, multiple power rails 220 may each be connected to input power sources having different voltage levels.

In some implementations, two adjacent source/drain patterns 151, 152 may each be connected to a different power rail 220. Referring to FIG. 2 and FIG. 5, the first source/drain pattern 151 and the second source/drain pattern 152 adjacent to the first source/drain pattern 151 may be connected to different power rails 220 to each other. Referring to FIG. 5, the first source/drain pattern 151 may be connected to a first power rail 221, and the second source/drain pattern 152 may be connected to a second power rail 222. The first source/drain pattern 151 may be connected to the first power rail 221 through the first lower contact electrode 181A. The second source/drain pattern 152 may be connected to the second power rail 222 through the second lower contact electrode 181B.

In some implementations, the power rail 220 may also be located on the lower surface of the base insulating layer 200. The power rail 220 may include a first portion 221a, 222a positioned at a level equal to or lower than the lower surface of the base insulating layer 200 and a second portion 221b, 222b positioned at a level equal to or higher than the lower surface of the base insulating layer 200.

In some implementations, the width of the first portion 221a, 222a along the horizontal direction (e.g., the first direction D1 or the second direction D2) may be wider than the width of the second portion 221b, 222b along the horizontal direction. Referring to FIGS. 2 and 5, the minimum width in the horizontal direction of the first portion 221a, 222a may be wider than the maximum width in the horizontal direction of the second portion 221b, 222b. At the boundary between the first portion 221a, 222a and the second portion 221b, 222b, the width of the first portion 221a, 222a in the horizontal direction may be wider than the width of the second portion 221b, 222b in the horizontal direction. The boundary between the first portion 221a, 222a and the second portion 221b, 222b may be positioned at substantially the same level as the lower surface of the base insulating layer 200.

The first portion 221a, 222a may extend along the second direction D2. Referring to FIG. 2 and FIG. 5, at least a portion of a side surface of the first portion 221a, 222a may be surrounded by an insulating liner 163 and/or a first lower insulating layer 173. The first portion 221a, 222a may have a side surface in contact with the insulating liner 163 and/or the first lower insulating layer 173. The first portion 221a, 222a may have an inclined side surface where the width in the first direction D1 gradually narrows as it approaches the lower surface of the base insulating layer 200 depending on the aspect ratio, but the width configuration is not limited thereto.

A portion of the entire upper surface area of the first portion 221a, 222a may cover a portion of the lower surface area of the base insulating layer 200. In some implementations, among the entire upper surface region of the first portions 221a, 222a, the remaining region excluding the region in contact with a lower surface of the second portions 221b, 222b may cover a lower surface of the base insulating layer 200.

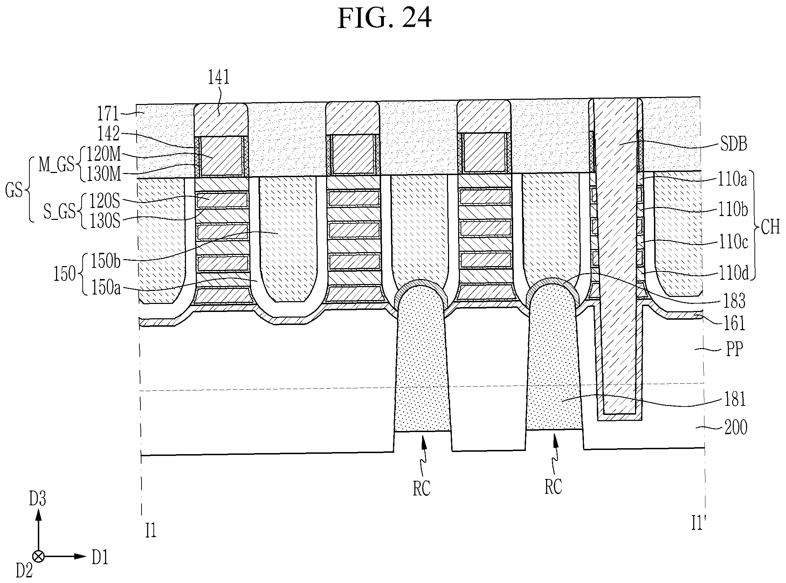

The second portion 221b, 222b may be positioned at a level higher than the lower surface of the base insulating layer 200. The upper surface of the second portion 221b, 222b may be in contact with the lower surface of the lower contact electrode 181. In some implementations, the second portion 221b, 222b may fill a recessed area RC (see FIG. 24) formed in the process of forming the lower contact electrode 181. The second portion 221b, 222b may have an inclined side surface where the width in the first direction D1 gradually increases as it approaches the upper surface of the first portion 221a, 222a depending on the aspect ratio, but is not limited thereto. At least a portion of the side surface of the second portion 221b, 222b may be surrounded by a base insulating layer 200.

In some implementations, the surface where the upper surface of the second power rail 222 and the base insulating layer 200 contact each other may be positioned at a level lower than a lower surface of the first lower contact electrode 181A. In some implementations, the surface where the upper surface of the second power rail 222 and the base insulating layer 200 contact each other may be located diagonally downward from the lower surface of the first lower contact electrode 181A.

Referring to FIG. 5, a first distance d1, which is the closest distance between the first lower contact electrode 181A and the first portion 222a of the second power rail 222, may be defined. The first distance d1 may be the distance between a first point P1 that is closest to the first portion 222a of the second power rail 222 among the entire area of the lower surface of the first lower contact electrode 181A, and a second point P2 that is closest to the first lower contact electrode 181A among the entire area of the upper surface of the first portion 222a of the second power rail 222.

In some implementations, the lower surface of the first lower contact electrode 181A may be positioned at a higher level than the lower surface of the base insulating layer 200, and thus, the first distance d1 may be longer in the semiconductor device shown in FIG. 5 compared to a case where the lower surface of the first lower contact electrode 181A is positioned at the same level as the lower surface of the base insulating layer 200. Accordingly, the first portion 221a, 222a of the power rails 221, 222 may be sufficiently spaced apart from the lower contact electrode 181A, 181B connected to another power rail 221, 222 adjacent thereto.

Accordingly, the distance between the power rail 220 and the lower contact electrode 181 connected to another power rail 220 adjacent thereto may be increased. For example, the distance between a portion of the power rail 220 located at a lower level than the lower surface of the base insulating layer 200 and the lower contact electrode 181 connected to another power rail 220 adjacent to the power rail 220 may be increased. Accordingly, in the process of forming the power rail 220 on the back side of the semiconductor device, edge placement error (EPE) may be reduced, thereby reducing process complexity, and time dependent dielectric breakdown (TDDB) may also be reduced, thereby improving the reliability of the semiconductor device.

The power rail 220 may include a conductive material. In some implementations, the power rail 220 may include at least one of a metal, a metal alloy, a conductive metal nitride, a conductive metal carbide, a conductive metal oxide, a conductive metal carbonitride, and a two-dimensional (2D) material. The metal may include at least one of copper (Cu), titanium (Ti), tantalum (Ta), tungsten (W), nickel (Ni), cobalt (Co), and platinum (Pt). The conductive metal nitride may include at least one of titanium nitride (TiN), tantalum nitride (TaN), tungsten nitride (WN), nickel nitride (NiN), cobalt nitride (CoN), and platinum nitride (PtN).

In some implementations, the first portion 221a, 222a and the second portion 221b, 222b of the power rail 220 may include the same material. In this case, the boundary between the first portion 221a, 222a and the second portion 221b, 222b may not be recognized. However, this is not limited thereto, the first portion 221a, 222a and the second portion 221b, 222b may contain different materials.

The semiconductor device may further include an upper contact electrode that electrically connects the upper wiring structure positioned over the interlayer insulating layer 171 to the source/drain pattern 150 or the main gate electrode 120M. For example, the upper contact electrode may penetrate a portion of the interlayer insulating layer 171 positioned over the source/drain patterns 150 to connect the source/drain patterns 150 and the upper wiring structure. For example, the upper contact electrode may penetrate a portion of the interlayer insulating layer 171 positioned over the gate structure GS, and may connect the main gate electrode 120M to the upper wiring structure.

In some implementations, an electric signal or power voltage supplied from the outside may be provided to the source/drain patterns 150 through a power rail 220 located on the lower surface of the base insulating layer 200. In some implementations, when the semiconductor device includes an upper wiring structure, an electric signal or power voltage supplied from the outside may be provided to the source/drain patterns 150 or the main gate electrodes 120M through a power rail 220 located on the lower surface of the upper wiring structure and/or the base insulating layer 200.

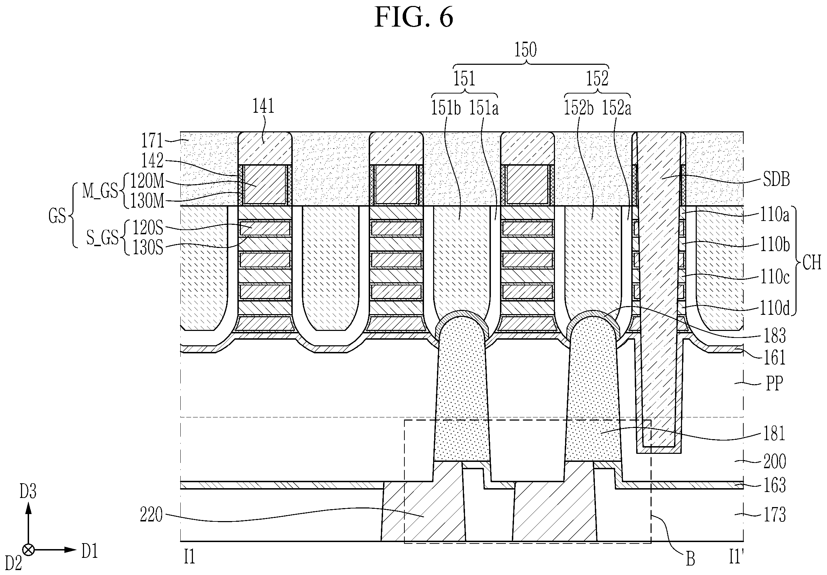

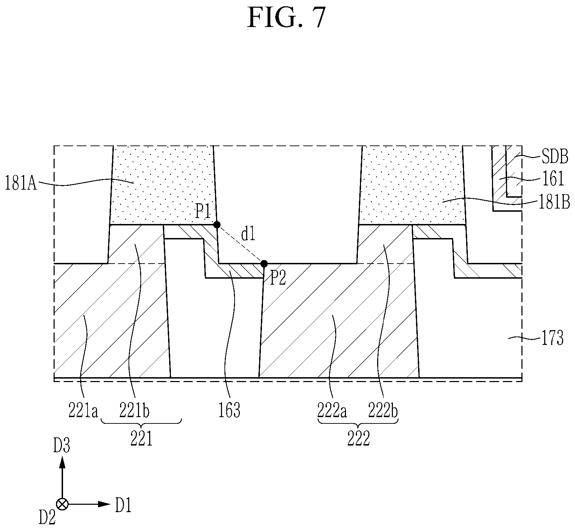

FIGS. 6 and 7 are drawings illustrating another example of a semiconductor device. Specifically, FIG. 6 is a cross-sectional view of the semiconductor device along line I1-I1' of FIG. 1, and FIG. 7 is an enlarged cross-sectional view of area 'B' of FIG. 6. The semiconductor device illustrated in FIGS. 6 and 7 is similar to that described with respect to FIGS. 1 to 5, so the following description focuses mainly on the differences from the previous example. Specifically, the position at which the power rail 220 is formed may be partially different from that shown in FIGS. 1 to 5. For example, FIGS. 6 and 7 illustrate a semiconductor device in which a photo mask is not precisely aligned during a process of etching a portion of the first lower insulating layer 173 and the insulating liner 163 to form the power rail 220.

Referring to FIGS. 6 and 7, the power rail 220 may cover only a portion of the lower surface of the lower contact electrode 181. In some implementations, the insulating liner 163 may cover a portion of a side surface of the base insulating layer 200. The insulating liner 163 may cover a portion of the side surface and lower surface of the recessed region RC (see FIG. 24) formed in the process of etching the lower region of the lower contact electrode 181. In some implementations, a portion of the lower surface of the lower contact electrode 181 that is not in contact with the upper surface of the power rail 220 may be covered by an insulating liner 163.

In some implementations, the lower surface of the first lower contact electrode 181A may be positioned at a higher level than the lower surface of the base insulating layer 200, and thus, the first distance d1 in the semiconductor device may be longer compared to a case where the lower surface of the first lower contact electrode 181A is positioned at the same level as the lower surface of the base insulating layer 200. Accordingly, even if the photo mask is not precisely aligned in the process of etching a portion of the first lower insulating layer 173, the second power rail 222 may be sufficiently spaced apart from the first lower contact electrode 181A connected to the first power rail 221.

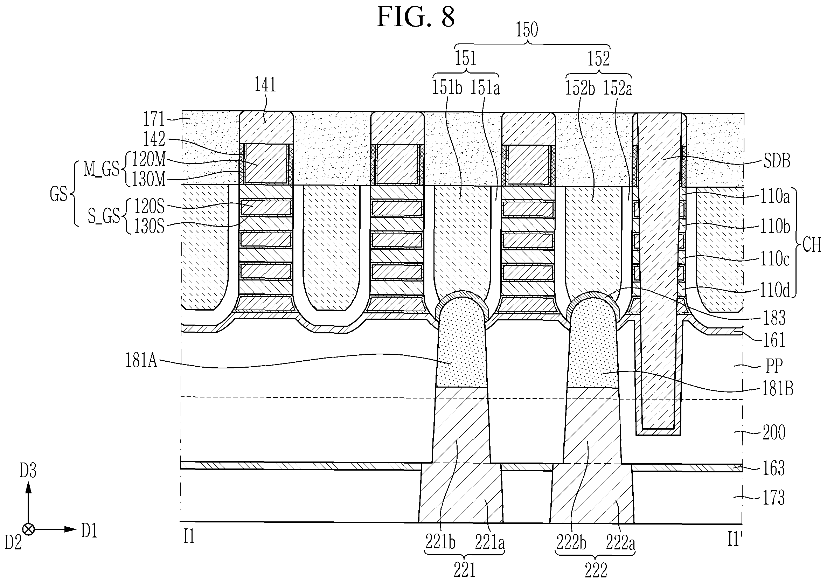

FIG. 8 is a drawing illustrating another example of a semiconductor device. Specifically, FIG. 8 is a cross-sectional view of a semiconductor device along line I1-I1' of FIG. 1. Since the semiconductor device illustrated in FIG. 8 is similar to that described with respect to FIGS. 1 to 7, the following description focuses mainly on the differences therebetween. Specifically, in some implementations, a level of the upper surface of the power rail 220 and a level at which the lower contact electrode 181 is positioned may be partially different from those described above.

Referring to FIG. 8, in some implementations, the lower surface of the lower contact electrode 181 may be positioned at a higher level than the lower surface of the protrusion pattern PP. Further, the lower contact electrode 181 may not overlap the base insulating layer 200 in the horizontal direction. In some implementations, the lower surface of the lower contact electrode 181 may be positioned at a higher level than the lower surface of the separating structure SDB.

In some implementations, the surface of the power rail 220 that is in contact with the lower contact electrode 181 may be positioned at a higher level than the upper surface of the base insulating layer 200, and accordingly, the first distance d1 (see FIG. 5), which is the closest distance between the first lower contact electrode 181A and the first portion 222a of the second power rail 222, may be longer compared to the semiconductor devices described with reference to FIG. 1 to FIG. 7.

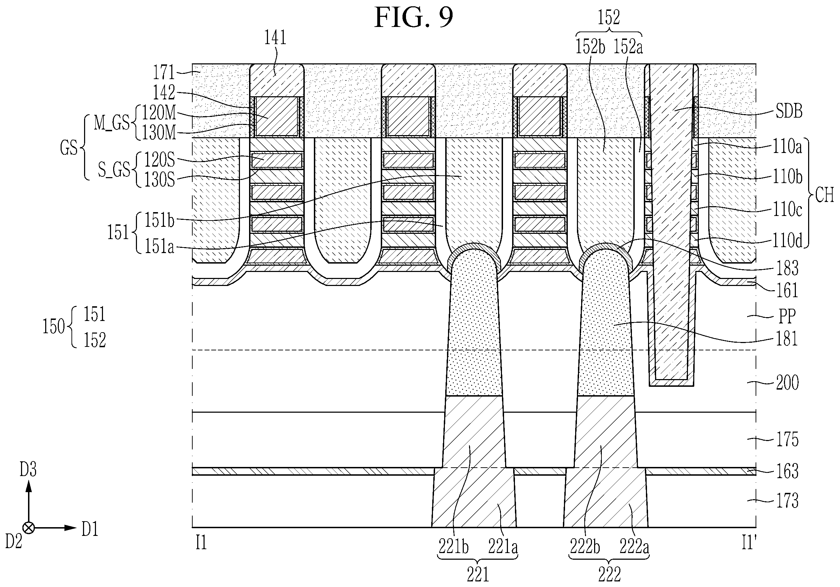

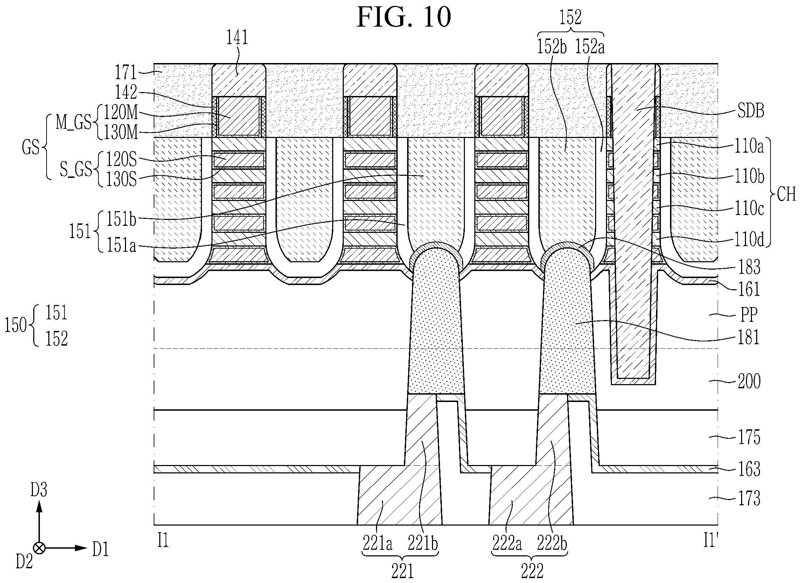

FIG. 9 and FIG. 10 are drawings illustrating further examples of semiconductor devices. Specifically, FIG. 9 and FIG. 10 are cross-sectional views of a semiconductor device along line I1-I1' of FIG. 1. The semiconductor devices illustrated in FIGS. 9 and 10 are similar to those described with respect to FIGS. 1 to 8, the following description focuses mainly on the differences therebetween. Specifically, the semiconductor device may be partially different from some implementations of the foregoing examples in that it further includes a second lower insulating layer 175. FIG. 10 may illustrate a semiconductor device in which a photo mask is not precisely aligned during a process of etching a portion of a first lower insulating layer 173, an insulating liner 163, and a second lower insulating layer 175 to form a power rail 220.

Referring to FIGS. 9 and 10, in some implementations, a second lower insulating layer 175 may be positioned between the base insulating layer 200 and the first lower insulating layer 173. An insulating liner 163 may be positioned between the second lower insulating layer 175 and the first lower insulating layer 173. The second lower insulating layer 175 may cover a portion of the side surface of the second portion 221b, 222b of the power rails 221, 222.

The second lower insulating layer 175 may include an insulating material. In some implementations, the second lower insulating layer 175 may include a low-k material. For example, the second lower insulating layer 175 may include an insulating material having a lower dielectric constant than silicon oxide (SiO₂). For example, the second lower insulating layer 175 may include, at least one of silicon carbide (SiOC), silicon oxide (SiO₂), aluminum oxide (AlO_{X}), aluminum silicon oxide (AlSiO_{X}), or zirconium oxide (ZrO_{X}), but is not limited thereto.

In some implementations, the second lower insulating layer 175 may include a different insulating material than the first lower insulating layer 173. However, it is not limited thereto, and the second lower insulating layer 175 may include the same insulating material as the first lower insulating layer 173.

By including the second lower insulating layer 175 between the base insulating layer 200 and the first lower insulating layer 173, a distance between the first portion 220a, 220b of the power rail 220, which is positioned at a level lower than a bottom surface of the base insulating layer 200, and the lower contact electrode 181 connected to another adjacent power rail 220 may be increased in the semiconductor device, as compared to the semiconductor device described with reference to FIGS. 1 to 7.

When the second lower insulating layer 175 includes a low-k insulating material, the parasitic capacitance between the two power rails 221, 222 may be reduced, and thus the electrical characteristics of the semiconductor device may be improved.

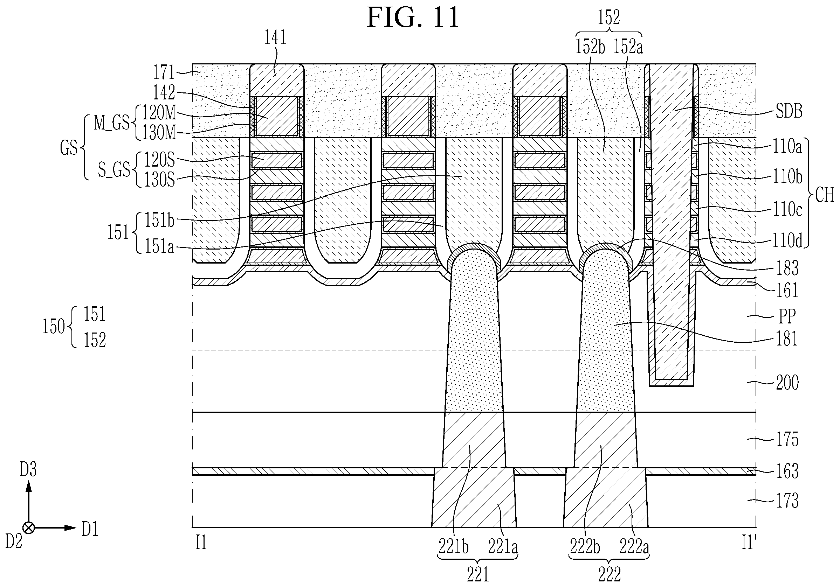

FIG. 11 is a drawing illustrating another example of a semiconductor device. Specifically, FIG. 11 is a cross-sectional view of a semiconductor device along line 11-I1' of FIG. 1. Since the semiconductor device illustrated in FIG. 11 is similar to those described with respect to FIGS. 1 to 10, the following description focuses mainly on the differences therebetween. Specifically, the semiconductor device may be partially different from some implementations of the foregoing examples in that it includes the second lower insulating layer 175, and in that levels at which a bottom surface of the lower contact electrode 181 and an upper surface of the power rail 220 are positioned may differ.

Referring to FIG. 11, the lower surface of the lower contact electrode 181 may be positioned at substantially the same level as the lower surface of the base insulating layer 200. The upper surface of the power rail 220 may be positioned at substantially the same level as the lower surface of the base insulating layer 200.

The semiconductor device may further include a second lower insulating layer 175 positioned between the first lower insulating layer 173 and the base insulating layer 200. The second lower insulating layer 175 is the same as or similar to that described with reference to FIG. 9 and FIG. 10, so a detailed description thereof is omitted.

In some implementations, the lower surface of the lower contact electrode 181 may be positioned at the same level as a lower surface of the base insulating layer 200. However, due to the presence of the second lower insulating layer 175, the first portion 220a, 220b of the power rail 220, which is positioned at a level lower than the lower surface of the base insulating layer 200, may be sufficiently spaced apart from the lower contact electrode 181 connected to another adjacent power rail 220, as compared to the semiconductor device described with reference to FIG. 1 to FIG. 7.

FIG. 12 to FIG. 34 are drawings illustrating an example of a method for manufacturing the semiconductor devices described herein. FIG. 12, FIG. 14, FIG. 16, FIG. 18, FIG. 20, FIG. 22, FIG. 24, FIG. 26, FIG. 28, and FIG. 30 are cross-sectional views corresponding to areas cut along line I1-I1' of FIG. 1, and FIG. 13, FIG. 15, FIG. 17, FIG. 19, FIG. 21, FIG. 23, FIG. 25, FIG. 27, FIG. 29, and FIG. 31 are cross-sectional views corresponding to areas cut along line I2-I2' of FIG. 1.

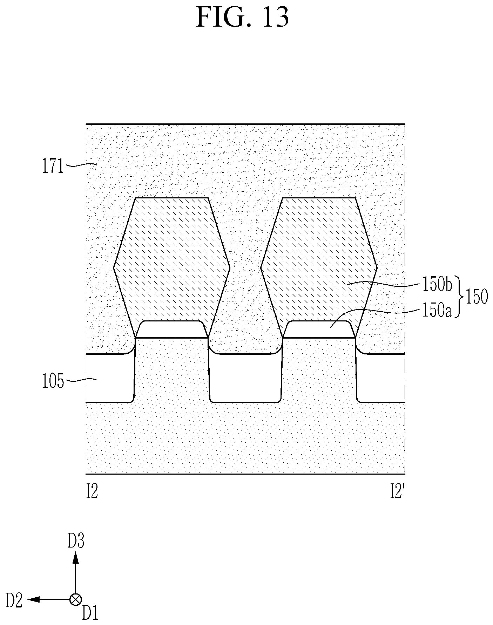

As illustrated in FIGS. 12 and 13, a lower pattern BP on a substrate 10, a field insulating layer 105 positioned on opposite sides of the lower pattern BP, channel structures CH positioned on the lower pattern BP, gate structure GS surrounding the channel structures CH, source/drain patterns 150 each connected to opposite sides of the channel structures CH, gate structure GS, and a separating structure SDB positioned on one side of the source/drain pattern 150 and penetrating the gate structure GS in a third direction D3 may be formed.

First, a lower pattern BP is formed on a substrate 10, and sacrificial layers and channel patterns 110a, 110b, 110c, 110d may be alternately laminated on the lower pattern BP. A field insulating layer 105 may be formed on opposite sides of the lower pattern BP. In some implementations, the substrate 10 may be silicon-on-insulator (SOI) or bulk silicon. As another example, the substrate 10 may be a silicon substrate, or may include other materials, such as, silicon germanium (SiGe), silicon germanium on insulator (SGOI), indium antimonide, lead tellurium compound, indium arsenide, indium phosphide, gallium arsenide, or gallium antimonide, but is not limited thereto.

Next, after etching a portion of region of the sacrificial layers and channel patterns 110a, 110b, 110c, 110d, source/drain patterns 150 may be formed using an epitaxial growth method. Next, after removing the sacrificial layers, gate structure GS may be formed in the region where the sacrificial layers were located. Next, source/drain patterns 150, an interlayer insulating layer 171 covering the gate structure GS and a capping layer 141 may be formed. Thereafter, a trench may be formed by etching through the capping layer 141, which is positioned at one side of the source/drain pattern 150, and the gate structure GS, to expose at least a portion of the lower pattern BP and the substrate 10. A separating structure SDB may then be formed by filling the trench. The width of the separating structure SDB along the first direction D1 may decrease as it extends from the top to the bottom in the third direction D3, but is not limited thereto.

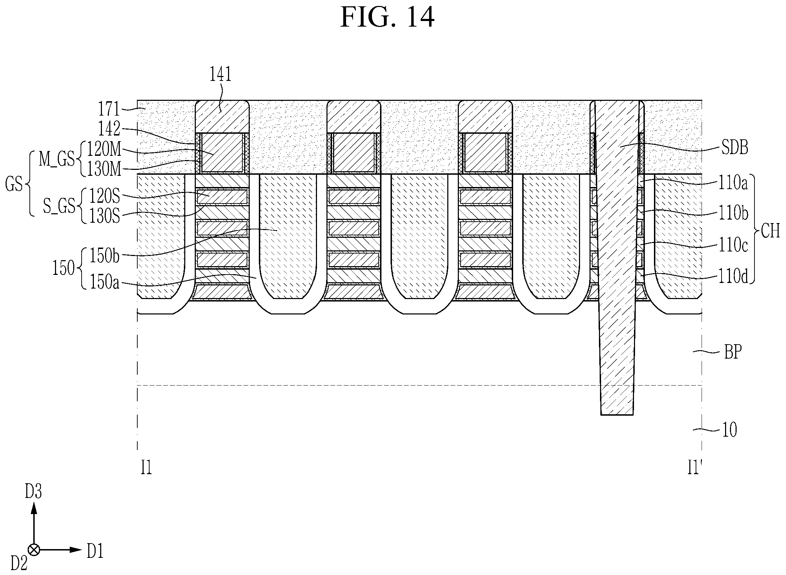

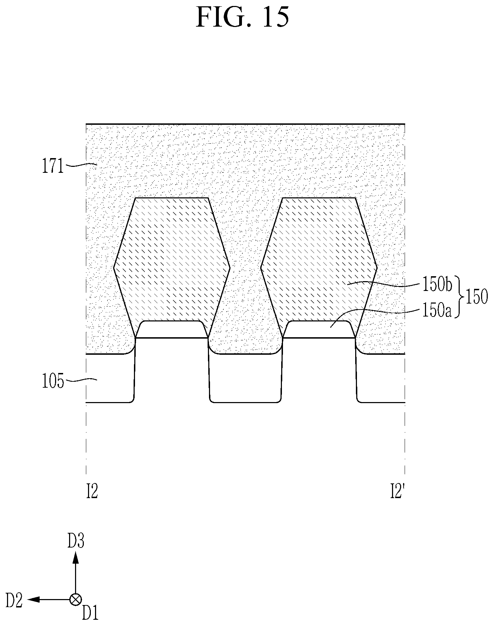

As illustrated in FIG. 14 and FIG. 15, the substrate 10 and the lower pattern BP may be removed. To etch the substrate 10 and the lower pattern BP, the semiconductor device may be turned over and the upper surface may be attached to a separate carrier substrate. For example, after the upper surface of the semiconductor device is positioned so that it faces one surface of the carrier substrate, the one surface of the carrier substrate and the upper surface of the semiconductor device may be attached to each other.

After this, an etching process may be performed so that the entire area of the substrate 10 and the lower pattern BP may be removed. To remove the substrate 10 and the lower pattern BP, at least one of wet etching, dry etching, and CMP (chemical mechanical polishing) processes may be performed. For example, the substrate 10 may first be etched to a sufficiently thin thickness by a CMP process, and then the remaining substrate 10 and lower pattern BP may be etched by a wet etching process. The wet etching process may be performed for a sufficient time so that the substrate 10 and the lower pattern BP do not remain. While the substrate 10 and the lower pattern BP are etched, at least a portion of the lower region of the source/drain patterns 150 may be doped with carbon (C) or boron (B) at a predetermined concentration to prevent the source/drain patterns 150 from being damaged. As the substrate 10 and the lower pattern BP are etched, a lower region of the channel structure CH, a lower region of the source/drain patterns 150, and a portion of the lower region of the separating structure SDB may be exposed.

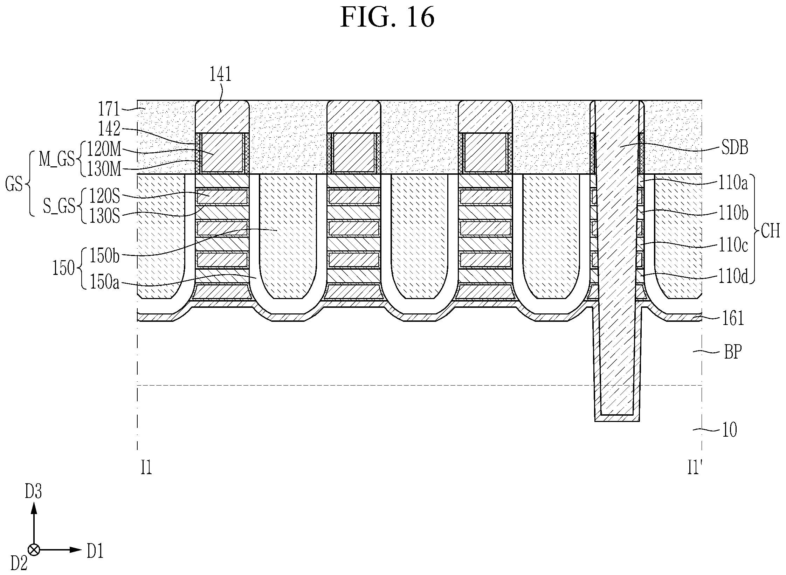

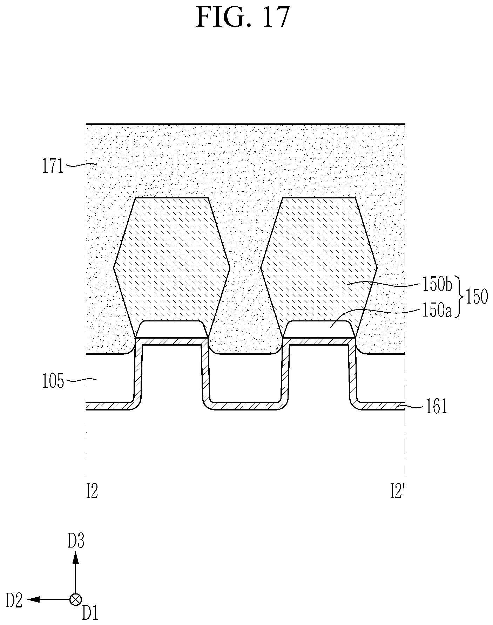

As illustrated in FIGS. 16 and 17, a barrier layer 161 may be formed on the lower surface of the gate structure GS, the lower surface of the source/drain pattern 150, and the lower surface and side surfaces of the field insulating layer 105. The barrier layer 161 may be used to protect the source/drain pattern 150, in the process of etching the base insulating layer 200 to form the lower contact electrode 181, to be described later. As another example, it may be to prevent impurities from penetrating into the gate structure GS from the base insulating layer 200 or the protrusion pattern PP to be formed in a subsequent process. In some implementations, the barrier layer 161 may include an insulating material. The barrier layer 161 may include silicon oxide (SiO₂), silicon nitride (SiN_{X}), silicon oxynitride (SiON), or a combination thereof.

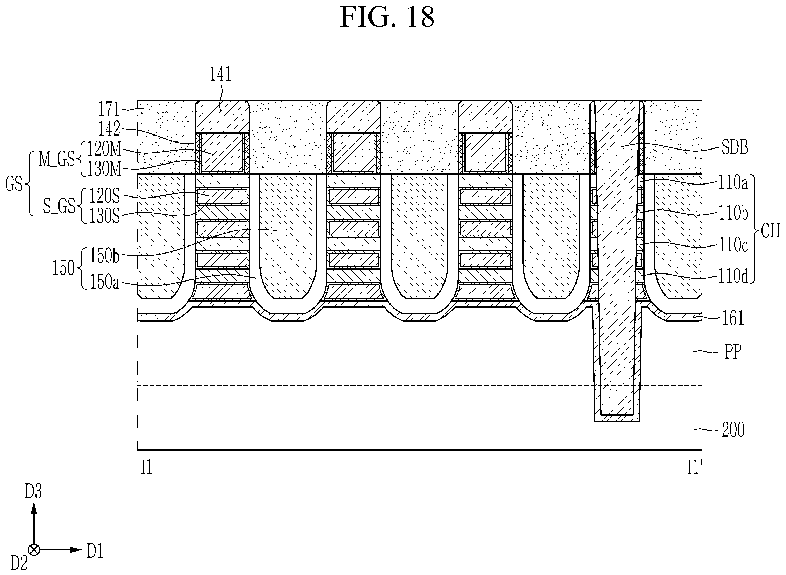

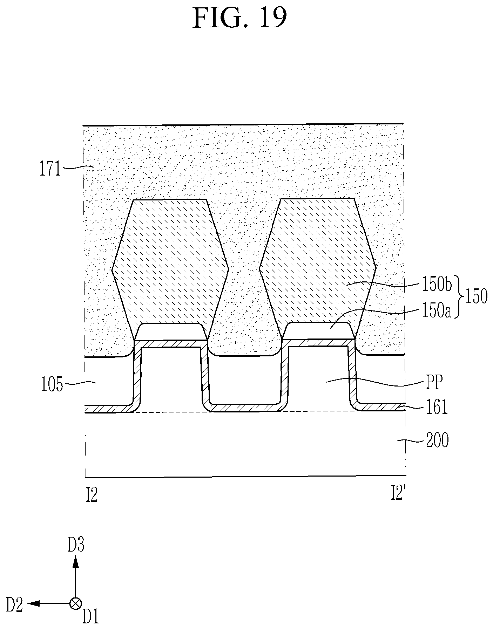

As illustrated in FIG. 18 and FIG. 19, an insulating material may be embedded in the etched portion of the substrate 10 and the lower pattern BP to form a base insulating layer 200 and a protrusion pattern PP, respectively. The protrusion pattern PP may be located on the lower surface of the barrier layer 161. The base insulating layer 200 may be positioned on the lower surface of the protrusion pattern PP or on the lower surface of the barrier layer 161. The protrusion pattern PP and the base insulating layer 200 may be formed simultaneously in the same process. In some implementations, the protrusion pattern PP and the base insulating layer 200 may include the same insulating material. For example, the protrusion pattern PP and the base insulating layer 200 may include silicon oxide (SiO₂), but are not limited thereto.

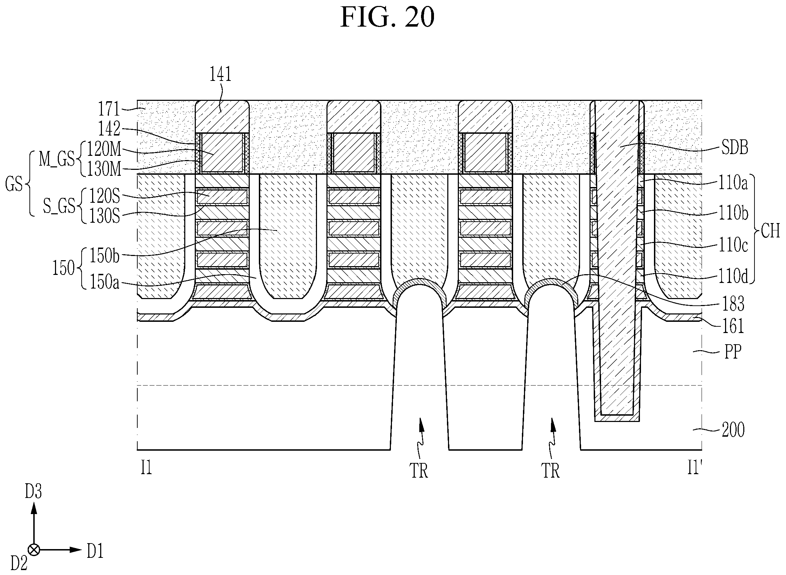

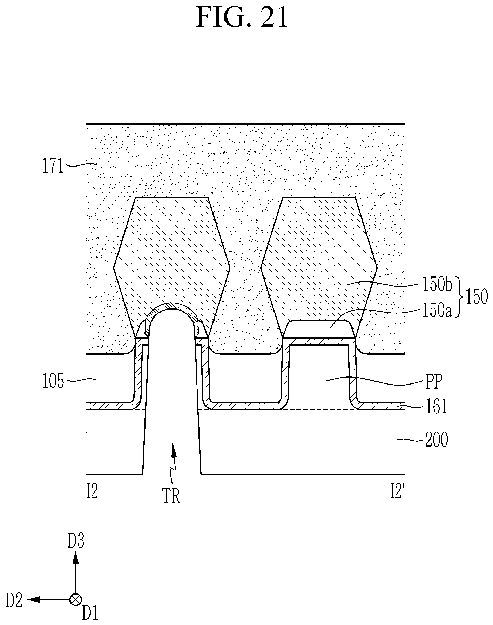

As illustrated in FIG. 20 and FIG. 21, a trench TR penetrating through a portion of the base insulating layer 200, the protrusion pattern PP, and the barrier layer 161 in the third direction D3 may be formed under at least one of the source/drain patterns 150. The trench TR may penetrate the protrusion pattern PP and the barrier layer 161 in the third direction D3 and be recessed into the interior of the source/drain pattern 150. A trench TR may be formed by etching at least a portion of the base insulating layer 200, the protrusion pattern PP, the barrier layer 161, and the source/drain pattern 150. The side surfaces of the trench TR may be defined by a base insulating layer 200, a protrusion pattern PP, and a source/drain pattern 150. The bottom surface of the trench TR may be defined by a source/drain pattern 150.

In some implementations, the trench TR may be formed by a dry etching process. For example, the process of forming a trench TR may be performed by Reactive Ion Etching (RIE) or Inductively Coupled Plasma (ICP). However, it is not limited to this, and the trench TR may also be formed by a wet etching process.

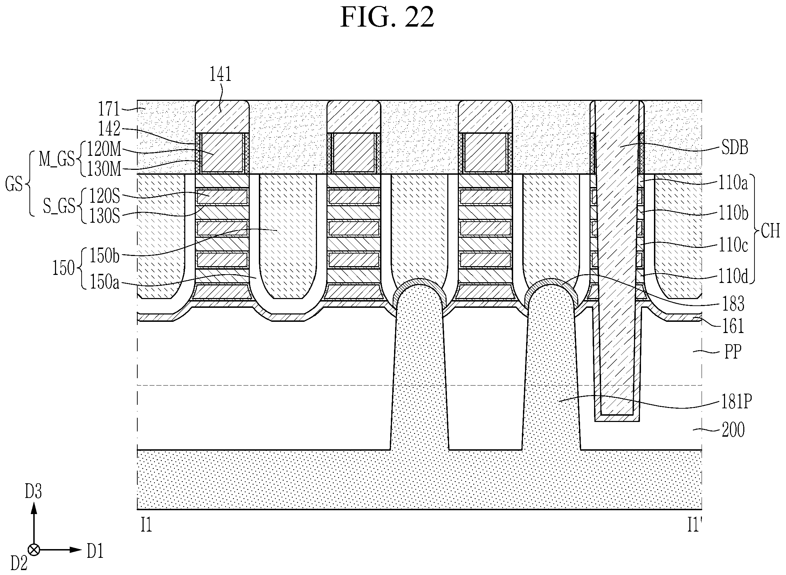

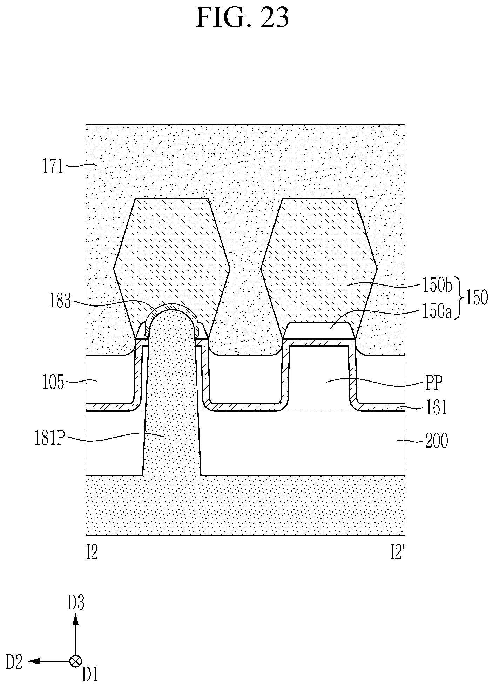

As illustrated in FIG. 22 to FIG. 25, the inside of the trench TR may be filled with a conductive material to form the lower contact electrode 181. First, as illustrated in FIG. 22 and FIG. 23, a conductive material may be deposited entirely on the inside of the trench TR and the lower surface of the base insulating layer 200 to form a lower contact electrode material layer 181P. A silicide layer 183 may be formed at the interface between the source/drain pattern and the lower contact electrode 181. The lower contact electrode material layer 181P may be formed by sputtering or evaporation, but is not limited thereto.

After this, a portion of the lower region of the lower contact electrode material layer 181P may be removed to form the lower contact electrode 181. Specifically, among the entire region of the lower contact electrode material layer 181P, a portion of the lower contact electrode material layer 181P located below the lower surface of the base insulating layer 200 may be removed. The process of removing a portion of the lower contact electrode material layer 181P may be performed by a chemical mechanical polishing process.

In some implementations, the chemical mechanical polishing process may be performed in two steps. In the first step, the lower contact electrode material layer 181P located at a level lower than the lower surface of the base insulating layer 200 may be quickly removed. For example, to rapidly etch the lower contact electrode material layer 181P, a slurry with a high concentration of abrasive particles may be used, or a pad with high stiffness may be used. As another example, in a chemical mechanical polishing process, the polishing platen may be rotated at high pressure or high rotational speed. The first step may be performed until the lower surface of the base insulating layer 200 is exposed by a chemical mechanical polishing process.

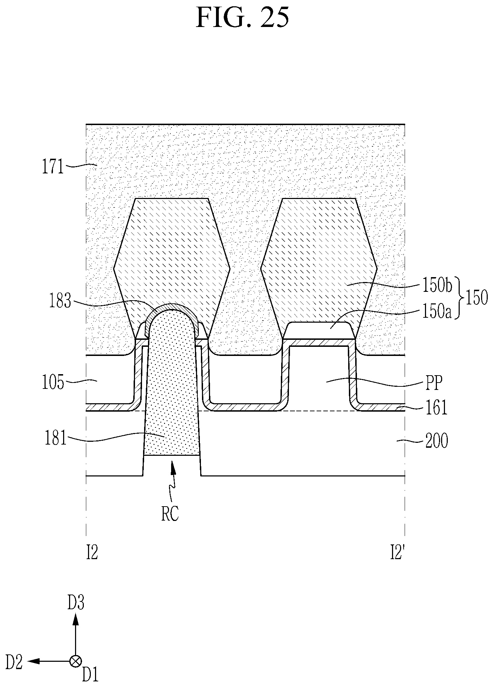

As illustrated in FIG. 24 and FIG. 25, even if the first step is performed only until the lower surface of the base insulating layer 200 is exposed, the lower contact electrode material layer 181P may be further etched to an area located at a higher level than the lower surface of the base insulating layer 200. This may be due to corrosion of the metal material during the chemical mechanical polishing process. For example, when the lower contact electrode material layer 181P includes a metal material, even if the chemical mechanical polishing process is performed only until the lower surface of the base insulating layer 200 is exposed, the lower contact electrode material layer 181P may be etched up to a portion of the lower contact electrode material layer located at a level higher than the lower surface of the base insulating layer 200. Accordingly, a recessed region RC as shown in FIG. 24 and FIG. 25 may be formed under the lower surface of the lower contact electrode 181.

In the second step, a chemical mechanical polishing process may be performed to remove defects or fine scratches that may remain on the surface of the base insulating layer 200 or the lower contact electrode 181. For this purpose, compared to the first step, a slurry with a lower concentration of abrasive particles or a pad with a higher elasticity of the polishing pad may be used. As another example, compared to the first step, the polishing platen in the chemical mechanical polishing process may be rotated at a lower pressure or lower rotation speed.

In some implementations, the second step may be performed for a short period of time so that the recessed region RC is not completely removed by the chemical mechanical polishing process.

According to some implementations, a step may be formed between the lower surface of the lower contact electrode 181 and the lower surface of the base insulating layer 200 only by a chemical mechanical polishing process, without an additional etching process. In some implementations, the lower contact electrode 181 may include a metal that is not easily etched. For example, the lower contact electrode 181 may include at least one of copper (Cu), tungsten (W), or cobalt (Co). However, the material is not limited thereto, and the lower contact electrode 181 may include various conductive materials.

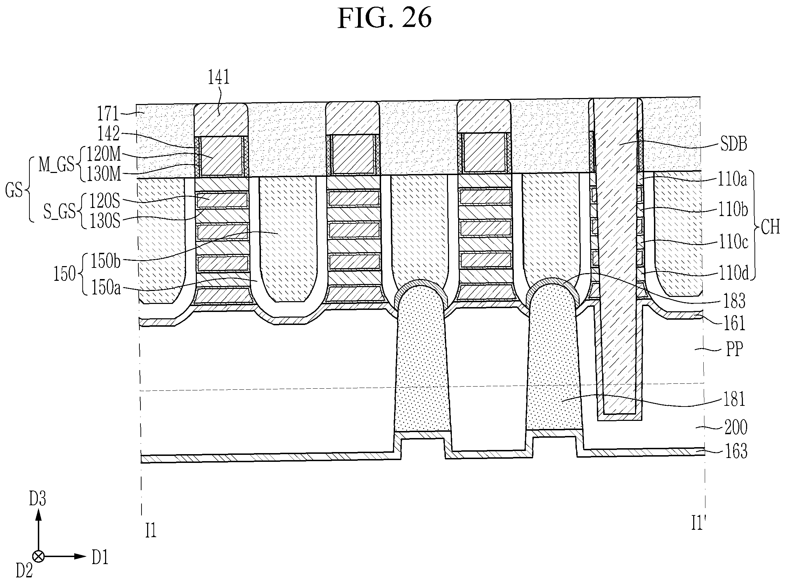

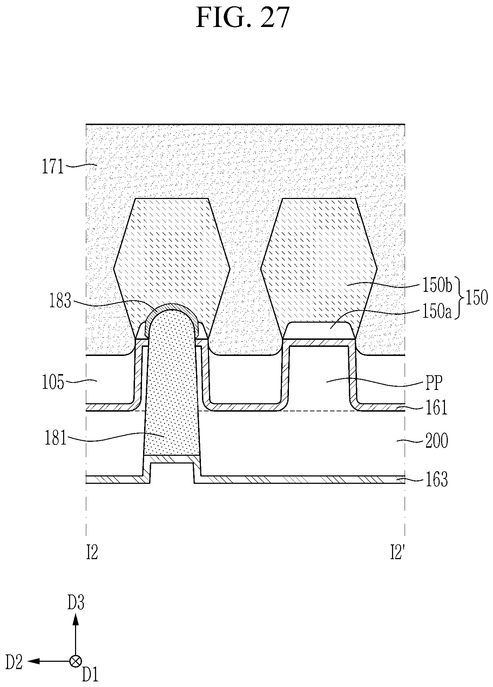

As illustrated in FIGS. 26 and 27, an insulating liner 163 may be formed that conformally covers the lower surface of the base insulating layer 200 and the side surface and lower surface of the recessed region RC. The insulating liner 163 may include silicon oxide (SiO₂), silicon nitride (SiNX), silicon oxynitride (SiON), or a combination thereof, but is not limited thereto.

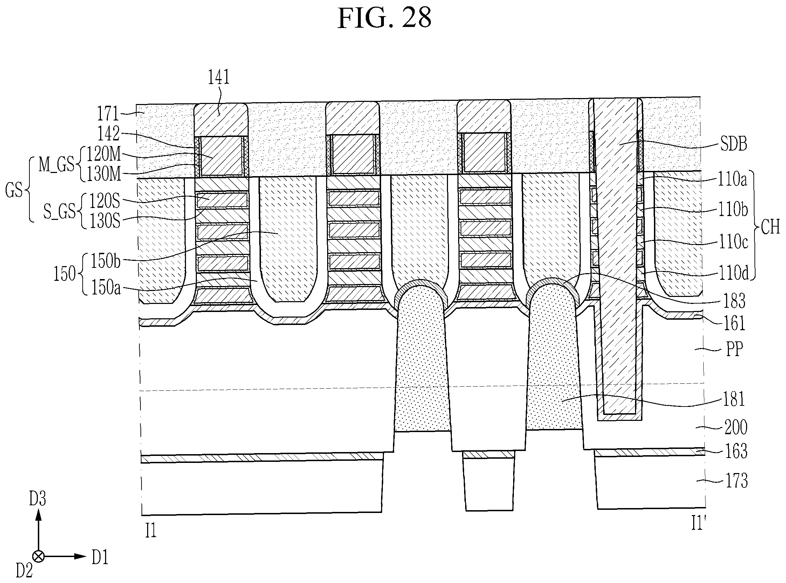

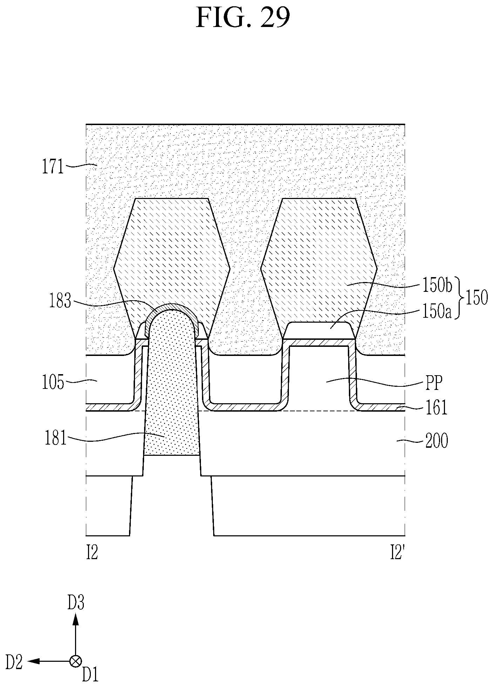

Next, as illustrated in FIG. 28 and FIG. 29, a first lower insulating layer 173 covering the entire insulating liner 163 may be formed, and the first lower insulating layer 173 overlapping the lower contact electrode 181 in the third direction D3 and a portion of the insulating liner 163 may be etched to expose the lower surface of the lower contact electrode 181.

First, a first lower insulating layer 173 may be deposited to completely cover the insulating liner 163, and then a photolithography and etching process may be performed to remove a portion of the first lower insulating layer 173 that overlaps the lower contact electrode 181 in the third direction D3. An insulating liner 163 may be used as an etching stop film. After this, a portion of the base insulating layer 200 and the insulating liner 163 covering the lower surface of the lower contact electrode 181 may be additionally etched to expose the lower surface of the lower contact electrode 181.

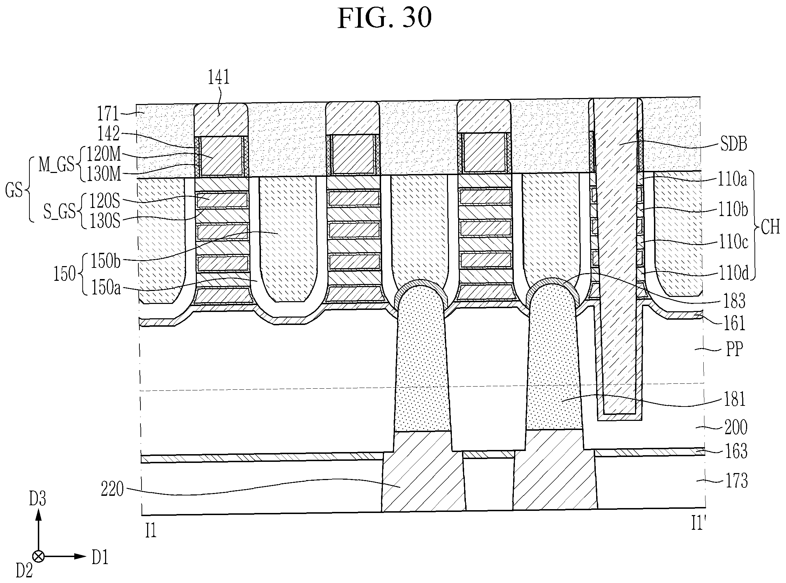

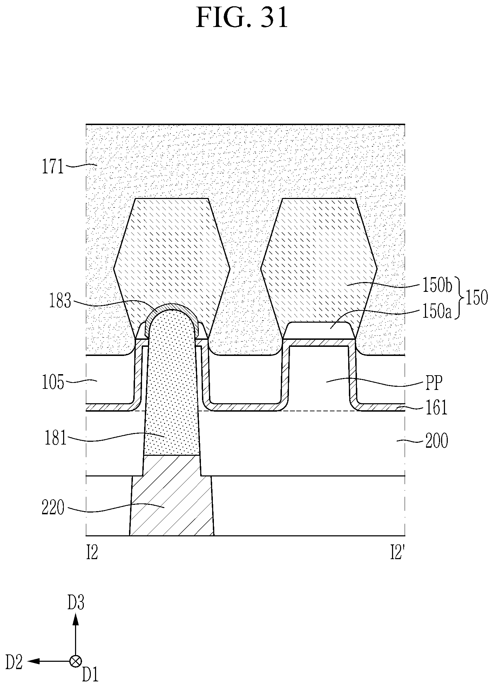

Next, as illustrated in FIGS. 30 and 31, a conductive material may be filled in an area where a portion of the first lower insulating layer 173 and the insulating liner 163 have been removed to form a power rail 220.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device, comprising:
a base insulating layer (200) comprising an upper surface and a lower surface opposing one another;
a channel structure (CH) on the upper surface of the base insulating layer (200);
a gate structure (GS) surrounding the channel structure (CH);
source/drain patterns (150) on the upper surface of the base insulating layer (200) and connected to the channel structure (CH);
power rails (220) on the lower surface of the base insulating layer (200); and
one or more lower contact electrodes (181) connecting one or more of the power rails (220) to one or more of the source/drain patterns (150),
wherein a lower surface of a first lower contact electrode (181A) of the one or more lower contact electrodes (181) is positioned at a level higher than the lower surface of the base insulating layer (200).

2. The semiconductor device of claim 1, wherein:
the source/drain patterns (150) include a first source/drain pattern (151) connected to a first side of the channel structure (CH) and a second source/drain pattern (152) connected to a second side of the channel structure (CH), wherein the first side of the channel structure (CH) and the second side of the channel structure (CH) are opposite to one another along a horizontal direction (D1);
the one or more lower contact electrodes (181) include the first lower contact electrode (181A) connected to the first source/drain pattern (151) and a second lower contact electrode (181B) connected to the second source/drain pattern (152);
the power rails (220) include a first power rail (221) connected to the first lower contact electrode (181A) and a second power rail (222) connected to the second lower contact electrode (181B); and
a surface at which the second power rail (222) and the lower surface of the base insulating layer (200) contact each other is positioned below the lower surface of the first lower contact electrode (181A) and spaced apart from the lower surface of the first lower contact electrode (181A) along the horizontal direction (D1).

3. The semiconductor device of claim 1, wherein each of the power rails (220) includes:
a first portion (221a, 222a) positioned at a level lower than the lower surface of the base insulating layer (200), and
a second portion (221b, 222b) positioned at a level higher than the lower surface of the base insulating layer (200),
wherein a smallest width of the first portion (221a, 222a) in a horizontal direction (D1) is greater than a largest width of the second portion (221b, 222b) in the horizontal direction (D1).

4. The semiconductor device of claim 3, wherein an upper surface of the first portion (221a, 222a) of each of the power rails (220) is in contact with the lower surface of the base insulating layer (200).

5. The semiconductor device of claim 3 or 4, wherein:
an upper surface of the second portion (221b, 222b) of a first power rail (221) of the power rails (220) is in contact with the lower surface of the first lower contact electrode (181A); and
the upper surface of the second portion (221b, 222b) of the first power rail (221) is positioned at a level higher than the lower surface of the base insulating layer (200).

6. The semiconductor device of any one of claims 3 to 5, comprising:
a first lower insulating layer (173) on the lower surface of the base insulating layer (200),
wherein a side surface of the first portion (221a) of a first power rail (221) of the power rails (220) is in contact with the first lower insulating layer (173), and
a side surface of the second portion (221b) of the first power rail (221) is in contact with the base insulating layer (200).

7. The semiconductor device of claim 6, comprising:
a second lower insulating layer (175) between the base insulating layer (200) and the first lower insulating layer (173),
wherein the side surface of the second portion (221b) of the first power rail (221) is in contact with the second lower insulating layer (175).

8. The semiconductor device of claim 7, wherein the first lower insulating layer (173) and the second lower insulating layer (175) comprise different insulating materials.

9. The semiconductor device of claim 7 or 8, wherein the second lower insulating layer (175) comprises a material having a dielectric constant lower than that of silicon oxide.

10. The semiconductor device of any one of claims 7 to 9, wherein the second lower insulating layer (175) comprises at least one of SiOC, SiO_{X}, AlO_{X}, AlSiO_{X}, or ZrO_{X}.

11. The semiconductor device of any one of claims 3 to 10, comprising:
a first lower insulating layer (173) on the lower surface of the base insulating layer (200); and
an insulating liner (163) between the base insulating layer (200) and the first lower insulating layer (173),
wherein a side surface of the first portion (221a) of a first power rail (221) of the power rails (220) is in contact with the insulating liner (163).

12. The semiconductor device of any one of claims 1 to 11, further comprising:
a protrusion pattern (PP) on the upper surface of the base insulating layer (200) and between the upper surface of the base insulating layer (200) and the source/drain patterns (150),
wherein the level at which the lower surface of the first lower contact electrode (181A) is positioned is higher than a lower surface of the protrusion pattern (PP).

13. The semiconductor device of any one of claims 1 to 12, wherein a difference in level between the lower surface of the base insulating layer (200) and the lower surface of the first lower contact electrode (181A) is greater than 0 nm and less than or equal to 8 nm.

14. The semiconductor device of any one of claims 1 to 13, wherein the first lower contact electrode (181A) comprises at least one of copper, tungsten, or cobalt.

15. The semiconductor device of any one of claims 1 to 14, further comprising:
a barrier layer (161) on a lower surface of the gate structure (GS) and on a lower surface of the source/drain patterns (150),
wherein the one or more lower contact electrodes (181) extend through the barrier layer (161).
